# EUROPEAN PATENT APPLICATION

(11) **EP 2 662 887 A1**
(43) Date of publication of application: **13.11.2013**
(21) Application number: 12785471.9
(22) Date of filing: 10.05.2012
(51) Int. Cl.: H01L 21/338, H01L 21/20, H01L 21/205, H01L 29/201, H01L 29/778, H01L 29/812

(54) **SEMICONDUCTOR ELEMENT AND METHOD FOR PRODUCING SAME**

(30) Priority: 17.05.2011 JP 2011110688
(71) Applicant: Advanced Power Device Research Association, Yokohama-shi, Kanagawa 220-0073 (JP)
(72) Inventor: KOKAWA, Takuya, Yokohama-shi Kanagawa 220-0073 (JP); KATOU, Sadahiro, Yokohama-shi Kanagawa 220-0073 (JP); IWAMI, Masayuki, Yokohama-shi Kanagawa 220-0073 (JP); UTSUMI, Makoto, Yokohama-shi Kanagawa 220-0073 (JP)
(74) Representative: Horn Kleimann Waitzhofer
(86) International application number: PCT/JP2012/003075
(87) International publication number: WO 2012/157227

(57) **Abstract**

Provided is a semiconductor device that includes a substrate, a first buffer region formed over the substrate, a second buffer region formed on the first buffer region, an active layer formed on the second buffer region, and at least two electrodes formed on the active layer. The first buffer region includes at least one composite layer in which a first semiconductor layer and a second semiconductor layer are sequentially stacked. The second buffer region in includes at least one composite layer in which a third semiconductor layer, a fourth semiconductor layer, and a fifth semiconductor layer are sequentially stacked. The fourth lattice constant has a value between the third lattice constant and the fifth lattice constant.

## Description

### BACKGROUND

### 1. TECHNICAL FIELD

The present invention relates to a semiconductor device and a method of manufacturing a semiconductor device. More specifically, the present invention relates to a semiconductor device with a small warpage and a small leakage current, and with which the thickness of films in the semiconductor device can be increased, and relates to a method of manufacturing the same.

### 2. RELATED ART

A semiconductor device having a buffer region and a nitride-based semiconductor region disposed over the buffer region has been known. The buffer region includes AlN layers and GaN layers alternatively deposited on a silicon substrate has been known. Such buffer region reduces a difference in lattice constant or thermal expansion coefficient between the silicon substrate and the nitride-based semiconductor region, and mitigates chances of cracks and dislocations. However, when a two-dimensional electron gas is generated at a hetero interface between the AlN layer and the GaN layer, a leakage current flows through the semiconductor device via the two-dimensional electron gas. As a solution to reduce this leakage current, an AlGaN layer is provided between the AlN layer and the GaN layer (for example, see Patent Document 1). The above mentioned Patent Document 1 is Japanese Patent No. 4525894.

However, with the conventional solutions, it is difficult to accommodate warpage of semiconductor devices in the buffer region. An amount of warpage in the buffer region depends on the thickness of the buffer region and materials of the layers in the buffer region. The thickness of the buffer region is determined in advance in consideration of a withstand voltage of the semiconductor device and so on, and therefore it would be difficult to change the thickness of the buffer region in order to control the amount of warpage. Thus, when the buffer region is formed from the alternatively deposited AlN layers, GaN layers, and AlGaN layers, it is difficult to control the amount of warpage.

### SUMMARY

Therefore, it is an object of an aspect of the innovations herein to provide a semiconductor device and a method of manufacturing the same, which are capable of overcoming the above drawbacks accompanying the related art. The above and other objects can be achieved by combinations described in the claims. A first aspect of the innovations may include a semiconductor device that includes a substrate, a first buffer region formed over the substrate, a second buffer region formed on the first buffer region, an active layer formed on the second buffer region, and at least two electrodes formed on the active layer. The first buffer region includes at least one composite layer in which a first semiconductor layer having a first lattice constant and a second semiconductor layer having a second lattice constant that is different from the first lattice constant are sequentially stacked. The second buffer region in includes at least one composite layer in which a third semiconductor layer having a third lattice constant that is substantially same as the first lattice constant, a fourth semiconductor layer having a fourth lattice constant, and a fifth semiconductor layer having a fifth lattice constant that is substantially same as the second lattice constant are sequentially stacked. Here, the fourth lattice constant has a value between the third lattice constant and the fifth lattice constant.

A second aspect of the innovations may include a method of manufacturing a semiconductor device. The method includes providing a substrate, forming a first buffer region over the substrate, forming a second buffer region on the first buffer region, forming an active layer on the second buffer region, forming at least two electrodes on the active layer. The forming the first buffer region includes repeating at least one cycle that includes forming a first semiconductor layer with a first lattice constant and then forming a second semiconductor layer with a second lattice constant, the forming the second buffer region includes repeating at least one cycle that includes forming a third semiconductor layer with a third lattice constant, forming a fourth semiconductor layer with a fourth lattice constant, and then forming a fifth semiconductor layer with a fifth lattice constant that is substantially same as the second lattice constant. Here, the fourth lattice constant has a value between the third lattice constant and the fifth lattice constant.

The summary clause does not necessarily describe all necessary features of the embodiments of the present invention. The present invention may also be a sub-combination of the features described above.

### BRIEF DESCRIPTION OF THE DRAWINGS

Fig. 1 is a sectional view of a semiconductor device according to a first embodiment of the present invention.
Fig. 2 is an explanatory drawing to illustrate a warpage direction and an amount of warpage of the whole of a wafer during growth of epitaxial layers on a substrate.
Fig. 3 illustrates a change in an Al composition ratio in a thickness direction of a second buffer region of the semiconductor device of Fig. 1.
Fig. 4 is an energy band diagram in a depth direction of a stack including a GaN layer and an AlN layer deposited sequentially.
Fig. 5 is an energy band diagram in a depth direction of the second buffer region of the semiconductor device of Fig. 1.
Fig. 6 illustrates another example of a change in an Al composition ratio in a fourth semiconductor layer of the semiconductor device of Fig. 1.
Fig. 7 illustrates another example of a change in the Al composition ratio in the fourth semiconductor layer of the semiconductor device of Fig. 1.
Fig. 8 illustrates another example of a change in Al composition ratio in the fourth semiconductor layer of the semiconductor device of Fig. 1.
Fig. 9 illustrates another example of a change in the Al composition ratio in the fourth semiconductor layer of the semiconductor device of Fig. 1.
Fig. 10 illustrates another example of a change in the Al composition ratio in the fourth semiconductor layer of the semiconductor device of Fig. 1.
Fig. 11 illustrates another example of a change in the Al composition ratio in the fourth semiconductor layer of the semiconductor device of Fig. 1.
Fig. 12 illustrates another example of a change in the Al composition ratio in the fourth semiconductor layer of the semiconductor device of Fig. 1.
Fig. 13 is a sectional view of a semiconductor device according to a second embodiment of the invention.
Fig. 14 illustrates a change in an Al composition ratio in a thickness direction of a second buffer region of the semiconductor device of Fig. 13.
Fig. 15 illustrates another example of a change in the Al composition ratio in fourth and sixth semiconductor layers of the semiconductor device of Fig. 13.
Fig. 16 illustrates another example of a change in the Al composition ratio in the fourth and sixth semiconductor layers of the semiconductor device of Fig. 13.
Fig. 17 illustrates another example of a change in the Al composition ratio in the fourth and sixth semiconductor layers of the semiconductor device of Fig. 13.
Fig. 18 illustrates another example of a change in the Al composition ratio in the fourth and sixth semiconductor layers of the semiconductor device of Fig. 13.
Fig. 19 illustrates another examples of changes in the Al composition ratio in the fourth and sixth semiconductor layers of the semiconductor device of Fig. 13.
Fig. 20 illustrates another example of a change in the Al composition ratio in the fourth and sixth semiconductor layers of the semiconductor device of Fig. 13.
Fig. 21 illustrates another example of a change in the Al composition ratio in the fourth and sixth semiconductor layers of the semiconductor device of Fig. 13.
Fig. 22 illustrates an example of a change in the Al composition ratio of a case where a very thin semiconductor layer is formed at the interface with an layer adjacent to the fourth semiconductor layer or the sixth semiconductor layer of the semiconductor device of Fig. 13.
Fig. 23 illustrates an example of a change in the Al composition ratio of a case where a very thin semiconductor layer is formed at the interface with an layer adjacent to the fourth semiconductor layer or the sixth semiconductor layer of the semiconductor device of Fig. 13.
Fig. 24 illustrates another example of a change in the Al composition ratio of a case where a very thin semiconductor layer is formed at the interface with an layer adjacent to the fourth semiconductor layer or the sixth semiconductor layer of the semiconductor device of Fig. 13.
Fig. 25 illustrates examples of an Al composition ratio of a case where layer thicknesses of the fourth and sixth semiconductor layers in each composite layer of the second buffer region of the semiconductor device of Fig. 13 are varied.
Fig. 26 illustrates a relationship in layer thickness between the fourth semiconductor layer 42 and the sixth semiconductor layer 44 in each composite layer of the semiconductor device of Fig. 13.
Fig. 27 illustrates relationship between a leakage current and an amount of warpage in a case where the total thickness of the semiconductor device shown in Fig. 13 is made constant, the total number of the composite layers is twelve, and only the number of the layers of the composite layer in the second buffer region is changed.
Fig. 28 illustrates a relationship between a leakage current and the thicknesses of the fourth semiconductor layer and the sixth semiconductor layer in the second buffer region of the semiconductor device of Fig. 13.
Fig. 29 illustrates relationship between the Al composition ratio in the fifth semiconductor layer and the leakage current in a case where all the fifth semiconductor layers in the semiconductor device of Fig. 13 are replaced by AlGaN.
Fig. 30 illustrates relationship between a leakage current and a C doping concentration in the second semiconductor layer and the fifth semiconductor layer of the semiconductor device of Fig. 13.
Fig. 31 illustrates relationship between a leakage current and a concentration of C doped in the first semiconductor layer and the third semiconductor layer of the semiconductor device of Fig. 13.
Fig. 32 illustrates Examples 1 to 5 in which the layer thickness of the first semiconductor layer and the number of the composition layers in the first buffer region of the semiconductor device shown in Fig. 13, and the number of the composition layers and the layer thickness of the third semiconductor layer in the second buffer region of the semiconductor device shown in Fig. 13 are different.
Fig. 33 illustrates measurement results of the amount of warpage and the leakage current in Examples 1 to 5 shown in Fig. 32.

### DESCRIPTION OF EXEMPLARY EMBODIMENTS

Hereinafter, some embodiments of the present invention will be described. The embodiments do not limit the invention according to the claims, and all the combinations of the features described in the embodiments are not necessarily essential to means provided by aspects of the invention.

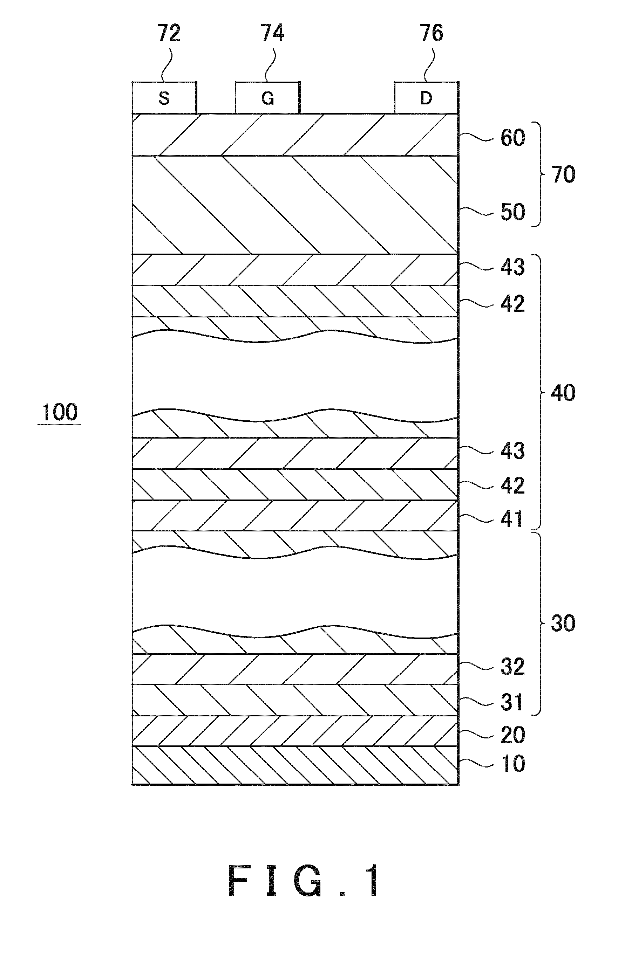

Fig. 1 is a sectional view of a semiconductor device 100 according to the first embodiment of the present invention. While an HEMT will be hereunder described as an example of the semiconductor device 100, the semiconductor device is not limited to this. The semiconductor device 100 includes a substrate 10, an interlayer 20, a first buffer region 30 formed over the substrate 10, a second buffer region 40 formed on the first buffer region, an active layer 70 formed on the second buffer region 40, and at least two electrodes (a source electrode 72, a gate electrode 74, and a drain electrode 76 in this example) formed on the active layer 70.

The substrate 10 serves as a supporting member for the first buffer region 30, the second buffer region 40 and the active layer 70. The substrate 10 may be a silicon monocrystal substrate with a main surface of the (111) plane. The main surface here refers to a surface where the first buffer region 30 and the second buffer region 40 are deposited. The substrate 10 has a diameter of, for example, 10 cm.

The interlayer 20 serves as an alloy inhibition layer that prevents chemical reaction between the substrate 10 and the first buffer region 30. The interlayer 20 is made of, for example, an undoped AlN. The lattice constant of the interlayer 20 may be smaller than that of the substrate 10. The coefficient of thermal expansion of the interlayer 20 may be larger than that of the substrate 10. When the substrate 10 is a silicon substrate, the lattice constant is 0.384 nm, and the coefficient of thermal expansion is 3.59×10⁻⁶/K. When the interlayer 20 is made of AlN, the lattice constant of the interlayer 20 is 0.3112 nm, and the coefficient of thermal expansion is 4.2×10⁻⁶/K. The thickness of the interlayer 20 is, for example, 40 nm.

The first buffer region 30 includes at least one composite layer in which a first semiconductor layer 31 with a first lattice constant and a second semiconductor layer 32 with a second lattice constant are sequentially stacked in the stated order. The second lattice constant is different from the first lattice constant. The first semiconductor layer 31 is formed on the interlayer 20. The first semiconductor layer 31 may have the first lattice constant that is smaller than the lattice constant of the substrate 10. The semiconductor layer 31 may have a larger coefficient of thermal expansion than that of the substrate 10. The first semiconductor layer 31 includes Alₓ₁In_{y1}Ga_{1-x1-y1}N (where 0 ≤ x1 < 1, 0 ≤ y1 ≤ 1, x1+y1 ≤ 1). The first semiconductor layer 31 is made of, for example, GaN. In this case, the first lattice constant of the first semiconductor layer 31 is 0.3189 nm, and the coefficient of thermal expansion is 5.59×10⁻⁶/K.

The second semiconductor layer 32 is formed in contact with the first semiconductor layer 31. The second semiconductor layer 32 may have the second lattice constant that is smaller than the first semiconductor layer 31. The second semiconductor layer 32 may have a larger coefficient of thermal expansion than that of the substrate 10. The second semiconductor layer 32 includes Alₓ₂In_{y2}Ga_{1-x2-y2}N (where 0 < x2 ≤ 1, 0 ≤ y2 ≤ 1, x2+y2 ≤ 1). The second semiconductor layer 32 is made of, for example, AlN. In this case, the second lattice constant of the second semiconductor layer 32 is 0.3112 nm, and the coefficient of thermal expansion is 4.2×10⁻⁶/K.

The first buffer region 30 relaxes a strain generated from differences in the lattice constant and the coefficient of thermal expansion between the substrate 10 and the active layer 70. Moreover, the first buffer region 30 accommodates warpage of an epitaxial substrate on which epitaxial growth has been performed. The first buffer region 30 has, for example, six composite layers in which the first semiconductor layer 31 and the second semiconductor layer 32 are sequentially deposited.

In each composite layer, the thickness of the first semiconductor layer 31 may be different. For example, the thickness of the first semiconductor layer 31 may increase as the distance from the substrate 10 increases. The thicknesses of the first semiconductor layers 31 are, for example, 130 nm, 150 nm, 180 nm, 210 nm, 250 nm, and 300 nm respectively stated from the one closest to the substrate 10. The thicknesses of the second semiconductor layers 32 may be constant and may be, for example, 60 nm.

The second buffer region 40 includes at least one composite layer in which a third semiconductor layer 41 with a third lattice constant, a fourth semiconductor layer 42 with a fourth lattice constant, and a fifth semiconductor layer with a fifth lattice constant are stacked in the stated order. The third lattice constant is substantially the same as the first lattice constant. The fifth lattice constant is substantially the same as the second lattice constant. The third semiconductor layer 41 is formed in contact with the second semiconductor layer 32 which is situated as a top layer. Here, the top layer refers to a layer farthest from the substrate 10. The third semiconductor layer 41 includes Alₓ₃In_{y3}Ga_{1-x3-y3}N (where 0 ≤ x3 < 1, 0 ≤ y3 ≤ 1, x3+y3 ≤ 1). The third semiconductor layer 41 is made of, for example, GaN. In this case, the third lattice constant of the third semiconductor layer 41 is 0.3189 nm, and the coefficient of thermal expansion is 5.59×10⁻⁶/K.

The fourth semiconductor layer 42 is formed in contact with the third semiconductor layer 41. The fourth semiconductor layer 42 has the fourth lattice constant that is between the third lattice constant and the fifth lattice constant. The fourth semiconductor layer 42 has a coefficient of thermal expansion between those of the third semiconductor layer 41 and the fifth semiconductor layer 43. The fourth semiconductor layer 42 includes Alₓ₄In_{y4}Ga_{1-x4-y4}N (where 0 < x4 ≤ 1, 0 ≤ y4 ≤ 1, x4+y4 ≤ 1). The fourth semiconductor layer 42 is made of, for example, AlGaN. The fourth semiconductor layer 42 has a lattice constant and coefficient of thermal expansion that are between those of GaN and AlN, and correspond to the Al composition ratio. The lattice constant of the fourth semiconductor layer 42 decreases from a point of the layer nearest to the substrate 10 to a point of the layer farthest from the substrate 10. In other words, the Al ratio in the fourth semiconductor layer 42 increases from the closest to the farthest to the substrate 10.

The fifth semiconductor layer 43 is formed in contact with the fourth semiconductor layer 42. The fifth semiconductor layer 43 includes Alₓ₅Iny5Ga_{1-x5-y5}N (where 0 < x5 ≤ 1, 0 ≤ y5 ≤ 1, x5+y5 ≤ 1). The fifth semiconductor layer 43 is made of, for example, AlN. In this case, the fifth lattice constant of the fifth semiconductor layer 43 is 0.3112 nm, and the coefficient of thermal expansion is 4.2×10⁻⁶/K. The first to fifth semiconductor layers 31 to 43 have Al composition relationships x1 ≈ x3, x2 ≈ x5, x1, x3 ≤ x4 ≤ x2, x5.

The second buffer region 40 relaxes strain generated from differences in the lattice constant and the coefficient of thermal expansion between the substrate 10 and the active layer 70. Moreover, strain generated from a difference in the lattice constant between the third semiconductor layer 41 and the fifth semiconductor layer 43 can be relaxed since the fourth semiconductor layer 42 is provided between the third semiconductor layer 41 and the fifth semiconductor layer 43. Consequently, the amount of the two-dimensional electron gas generated due to piezo polarization can be decreased. As a result, it is possible to relax the strain between the substrate 10 and the active layer 70 while maintaining a high resistivity of the buffer region.

The second buffer region 40 has, for example, six composite layers in each of which the third semiconductor layer 41, the fourth semiconductor layer 42, and the fifth semiconductor layer 43 are sequentially deposited. The thickness of the third semiconductor layer 41 may be different in each composite layer. For example, the thickness of the first semiconductor layer 31 may increase as the distance from the substrate 10 increases. For example, the thicknesses of the first semiconductor layers 31 which are arranged in the stack over the substrate 10 are 300 nm, 370 nm, 470 nm, 600 nm, 790 nm, and 1040 nm respectively, stated from the one closest to the substrate. The thicknesses of the fourth semiconductor layers 42 may be constant and may be, for example, 60 nm. The thicknesses of the fifth semiconductor layers 43 may be constant and may be, for example, 60 nm.

The active layer 70 has an electron transit layer 50, and an electron supply layer 60. The electron transit layer 50 is formed in contact with the top fifth semiconductor layer 43. The electron transit layer 50 generates a low-resistivity two-dimensional electron gas at a heterojunction interface with the electron supply layer 60. The electron transit layer 50 may include undoped GaN. The electron transit layer 50 has a thickness of, for example, 1200 nm. The electron supply layer 60 is formed in contact with the electron transit layer 50. The electron supply layer 60 supplies electrons to the electron transit layer 50. The electron supply layer 60 includes, for example, AlGaN doped with a n-type impurity such as Si. The electron supply layer 60 has a thickness of, for example, 25 nm.

The source electrode 72 and the drain electrode 76 may have a layered structure of Ti/Al that is in ohmic contact with the electron supply layer 60. The gate electrode 74 may have a layered structure of Pt/Au that is in schottky contact with the electron supply layer 60.

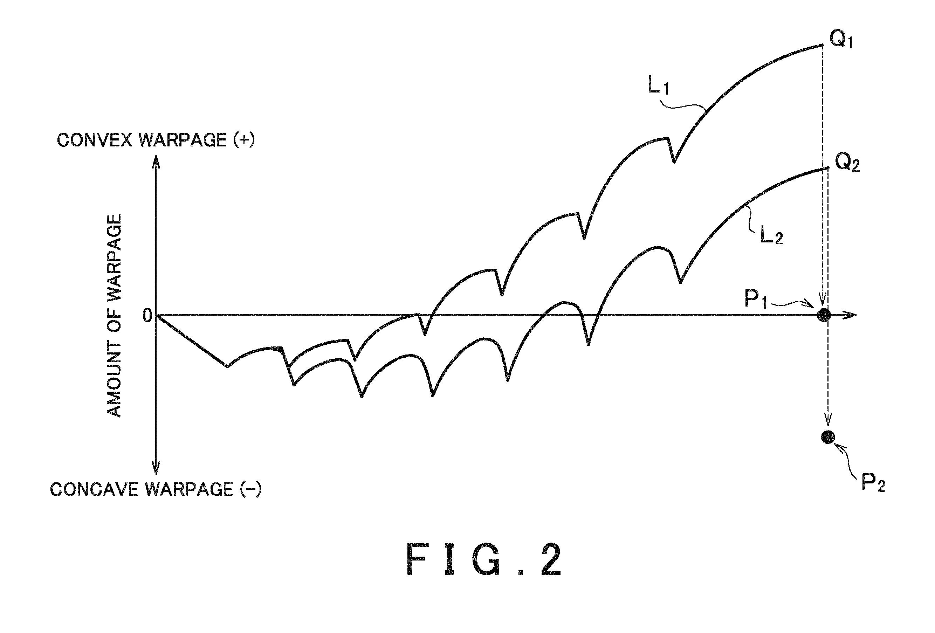

Fig. 2 is an explanatory drawing to illustrate a warpage direction and an amount of warpage of the whole of a wafer when epitaxial growth of the first buffer region 30 and the second buffer region 40 are epitaxially grown on the substrate 10. The horizontal axis shows the thickness of the layers and the vertical axis shows the amount of warpage where a warpage in a convex direction with respect to the deposited surface of the substrate 10 is indicated as plus and a warpage in a concave direction is indicated as minus.

In this example, the first buffer region 30 includes six composite layers of GaN/AlN and the active layer 70, and the second buffer region 40 includes six composite layers of GaN/AlGaN/AlN and the active layer 70. The line L1 shows the amount of warpage when the interlayer 20, the first buffer region 30, and the active layer 70 are epitaxially grown on the substrate 10. The line L2 shows the amount of warpage when the interlayer 20, the second buffer region 40, and the active layer 70 are epitaxially grown on the substrate 10.

Each layer is grown at a growth temperature between 900°C and 1300°C. The thickness of the GaN layer in the first buffer region 30 in this example is substantially same as the thickness of the GaN/AlGaN layers in the second buffer region 40. The thickness of the AlN layer in the first buffer region 30 in this example is substantially same as the thickness of the AlN layer in the second buffer region 40.

Referring to the line L1, a change in the amount of warpage when the composite layer of GaN/AlN that forms the first buffer region 30 is formed over the substrate 10 will be now described. The interlayer 20 is firstly formed on the substrate 10. Since the interlayer 20 includes AlN, it has a smaller lattice constant than that of the substrate 10 that includes Si. Thus, tensile stress works on the interlayer 20. As a result, warpage occurs in the minus direction.

Subsequently, the first semiconductor layer 31 is formed on and in contact with the interlayer 20. Since the first semiconductor layer 31 includes GaN, it has a larger lattice constant than that of the interlayer 20. Consequently, compressive stress works on the first semiconductor layer 31. As a result, warpage occurs in the plus direction. The second semiconductor layer 32 is then formed in contact with the first semiconductor layer 31 and on the first semiconductor layer 31. Since the second semiconductor layer 32 includes AlN, it has a smaller lattice constant that that of the first semiconductor layer 31. Thus, tensile stress works on the second semiconductor layer 32. As a result, warpage occurs again in the minus direction.

The active layer 70 is formed in contact with the second semiconductor layer 32 that is the top layer of the first buffer region 30. The amount of warpage of the whole wafer is Q1 in plus at the time when the epitaxial growth is finished. When the temperature of the substrate gets back to a room temperature, warpage occurs in the minus direction as the substrate temperature drops since the coefficients of thermal expansion of the interlayer 20, the first buffer region 30, and the active layer 70 are larger than that of the substrate 10. The amount of warpage of the whole wafer becomes ultimately, for example, P1 which is close to 0.

Referring to the line L2, a change in the amount of warpage when the composite layer of GaN/AlGaN/AlN that forms the second buffer region 40 is formed over the substrate 10 will be now described. The interlayer 20 is firstly formed on the substrate 10. As described above, the warpage caused by the interlayer 20 occurs in the minus direction. Subsequently, the third semiconductor layer 41 is formed on and in contact with the interlayer 20. As described above, warpage occurs in the plus direction since the third semiconductor layer 41 includes GaN.

Subsequently, the fourth semiconductor layer 42 is formed on and in contact with the third semiconductor layer 41. The fourth semiconductor layer 42 has a lattice constant between those of the third semiconductor layer 41 and the fifth semiconductor layer 43. Thus, tensile stress that gradually increases from the third semiconductor layer 41 toward the fifth semiconductor layer 43 works on the fourth semiconductor layer 42. Consequently, the warpage in the fourth semiconductor layer 42 occurs in the minus direction.

Subsequently, the fifth semiconductor layer 43 is formed on and in contact with the fourth semiconductor layer 42. Since the fifth semiconductor layer 43 includes AlN, it has a smaller lattice constant than that of the fourth semiconductor layer 42. Consequently, a tensile stress larger than that in the fourth semiconductor layer 42 works on the fifth semiconductor layer 43. As a result, warpage in the fifth semiconductor layer 43 occurs in the minus direction, and the amount of the warpage per unit thickness of the fifth semiconductor layer 43 is larger than that in the fourth semiconductor layer 42.

Because the second buffer region 40 includes the AlGaN layer, the active layer 70 is formed on the second buffer region 40, and an amount of warpage of the whole wafer becomes Q2 in plus which is smaller than Q1 when the epitaxial growth is finished. When the temperature of the substrate gets back to a room temperature, warpage occurs in the minus direction as the substrate temperature drops, because the coefficients of thermal expansion of the interlayer 20, the second buffer region 40, and the active layer 70 are larger than that of the substrate 10. The amount of warpage of the whole wafer becomes ultimately, for example, P2 which is largely in minus and different from P1. Because the warpage in the minus direction depends on the thickness, and the amount of change from Q1 to P1 is substantially same as the amount of change from Q2 to P2.

Referring again to Fig. 2, an amount of warpage in the first buffer region 30 is different from that in the second buffer region 40 even when these regions are epitaxially grown to the identical thickness. Thus, even when the total thickness of the first buffer region 30 and the second buffer region 40 are prescribed, a ratio of the thickness between the first buffer region 30 and the second buffer region 40 can be adjusted to accommodate the amount of warpage.

It was confirmed, in a first experimental example where only the second buffer region 40 was formed to satisfy the prescribed thickness, that the amount of the warpage of the wafer was 100 µm in the minus direction. Whereas in a second experimental example where the first buffer region 30 and the second buffer region 40 are both formed to achieve substantially the same thickness of the buffer region as that of the first experimental example, the amount of the warpage of the wafer was about 10µm in the minus direction. In this way, it is possible to realize a thick buffer region while reducing the amount of the warpage by combining the first buffer region 30 and the second buffer region 40.

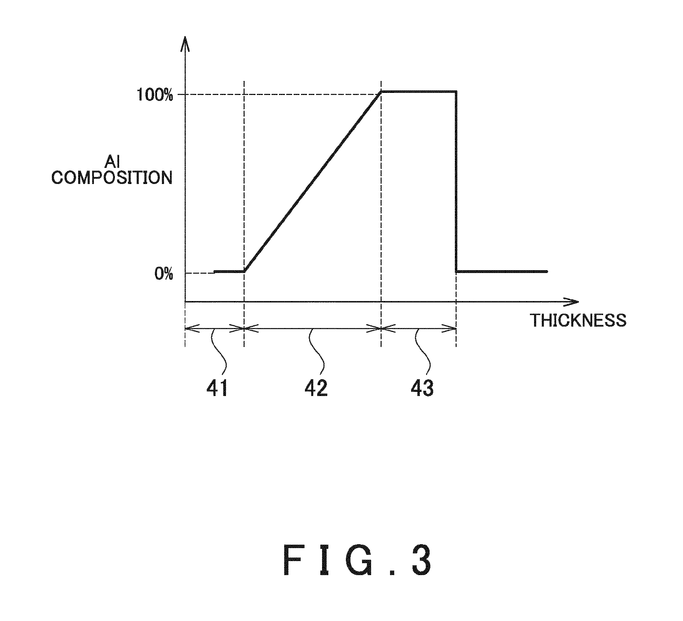

Fig. 3 illustrates a change in an Al composition ratio in the thickness direction of the second buffer region 40. Here, the Al ratio in the third semiconductor layer 41 is 0%, and the Al ratio in the fifth semiconductor layer 43 is 100%. However, the Al ratios are not limited to this. The Al ratio in the fourth semiconductor layer 42 linearly increases from the third semiconductor layer 41 toward the fifth semiconductor layer 43.

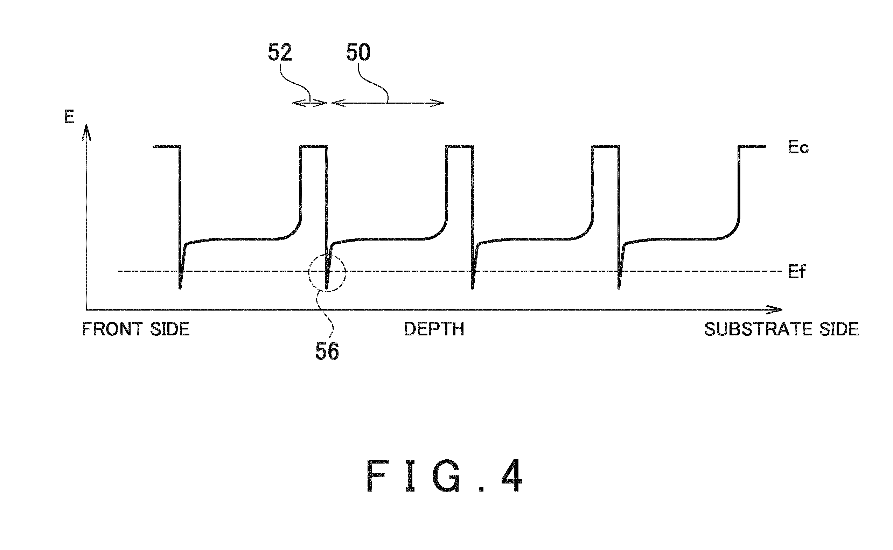

Fig. 4 is an energy band diagram in the depth direction of a stack structure including a GaN layer 54 and an AlN layer 52 deposited sequentially. The GaN layer 54 has a larger lattice constant that that of the AlN layer 52. When the AlN layer 52 having the smaller lattice constant than that of the GaN layer 54 is formed on the GaN layer 54, crystal strain occurs and a tensile stress works on the AlN layer 52. As a result, piezoelectric field polarization occurs at the hetero interface in addition to intrinsic polarization, and a triangle potential 56 in which a conduction band Ec protrudes lower than the Fermi level occurs. Electrons are accumulated in this field and a two-dimensional electron gas is generated. The resistivity is lowered in the region where the two-dimensional electron gas is generated, and the region becomes a path for leakage current.

The first buffer region 30 has a similar energy band to that of the example shown in Fig. 4, but the second buffer region 40 is provided between the first buffer region 30 and the active layer 70. Thus, it is possible to prevent the leakage current from running through the active layer 70 via the two-dimensional electron gas in the first buffer region 30. Moreover, by combining the first buffer region 30 and the second buffer region 40, it is possible to control the amount of warpage of the whole wafer.

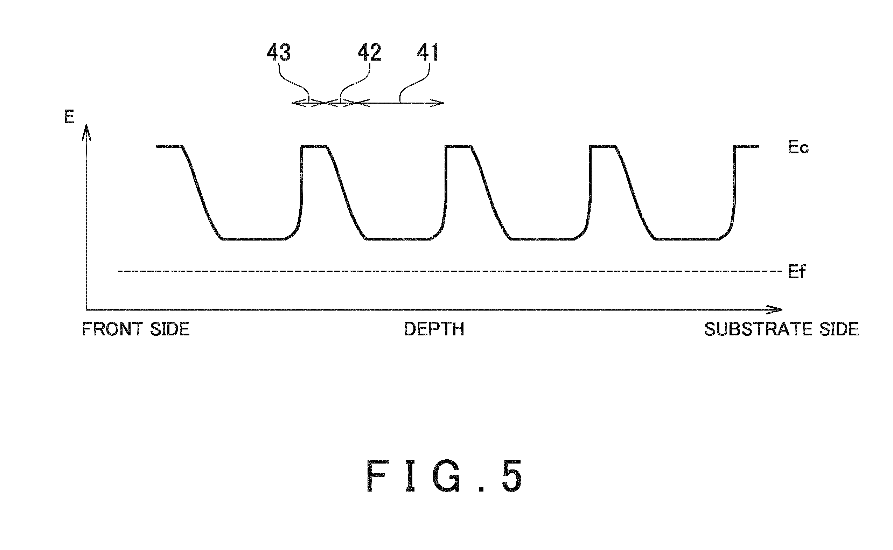

Fig. 5 is an energy band diagram in the depth direction of the second buffer region 40. The Al composition ratio in the fourth semiconductor layer 42 of this example changes gradually as illustrated in Fig. 3. In this case, the lattice constant of the fourth semiconductor layer 42 also gradually changes. Thus, a large strain does not occur at the bonded surface between the third semiconductor layer 41 and the fifth semiconductor layer 43, and the conduction band Ec does not change drastically but gradually. Therefore, carriers such as the two-dimensional electron gas are not generated, and the leakage current running through the second buffer region 40 is reduced.

A leakage current in the semiconductor device 100 in which only the first buffer region 30 was formed was measured. A leakage current in the semiconductor device 100 in which the first buffer region 30 and the second buffer region 40 were both formed was also measured. The first buffer region 30 had a layered structure of GaN/AlN, and the second buffer region 40 had a layered structure of GaN/AlGaN/AlN. The AlGaN layer had an Al composition ratio which changed gradually as illustrated in Fig. 3.

A leakage current running through the drain electrode 76 was measured under the conditions where the width of the gate electrode 74 was 1 mm, the length of the gate electrode 74 was 10 µm, the distance between the source electrode 72 and the drain electrode 76 is 15µm, the gate electrode 74 was supplied with a voltage of -6V, and a voltage of 600 V was applied between the source electrode 72 and the drain electrode 76. When only the first buffer region 30 was formed as the buffer region, the leakage current was about 1E-6 A. Whereas when the first buffer region 30 and the second buffer region 40 was provided to be combined to form the buffer region, the leakage current was about 1E-8 A. In this way, it was demonstrated that a large thickness can be achieved, the amount of the warpage can be prevented, and the leakage current can be reduced by combining the first buffer region 30 and the second buffer region 40.

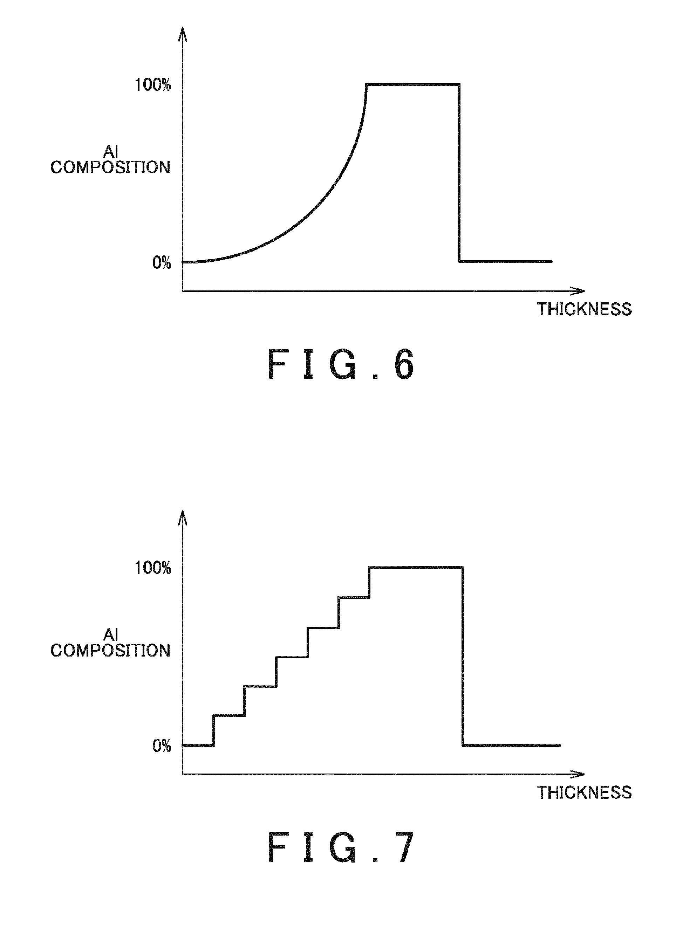

Fig. 6 illustrates another example of a change in the Al composition ratio in the fourth semiconductor layer 42. The Al composition ratio increases in a curved pattern from the third semiconductor layer 41 to the fifth semiconductor layer 43. The rate of increase of the Al composition ratio becomes larger as it gets closer to the fifth semiconductor layer 43. With such configuration, it is also possible to reduce the leakage current in the semiconductor device 100.

Fig. 7 illustrates another example of a change in the Al composition ratio in the fourth semiconductor layer 42. The Al composition ratio increases by a step of 5% from the third semiconductor layer 41 to the fifth semiconductor layer 43. When the fourth semiconductor layer 42 is configured in this way, it is also possible to reduce the leakage current in the semiconductor device 100.

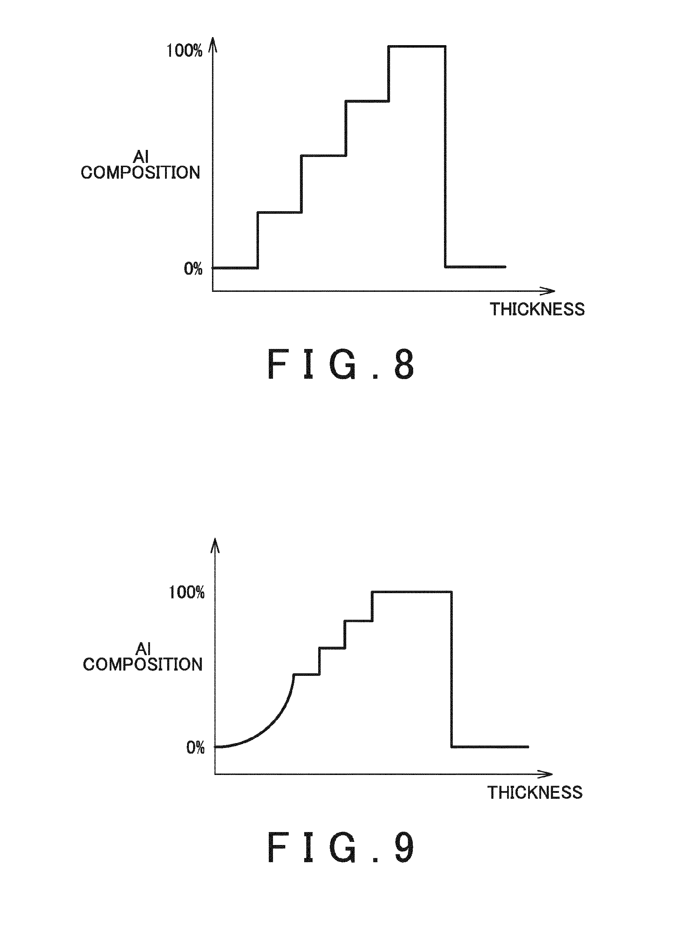

Fig. 8 illustrates another example of a change in the Al composition ratio in the fourth semiconductor layer 42. The Al composition ratio increases by a step of 25% from the third semiconductor layer 41 to the fifth semiconductor layer 43. When the fourth semiconductor layer 42 is configured in this way, it is also possible to reduce the leakage current in the semiconductor device 100.

Fig. 9 illustrates another example of a change in the Al composition ratio in the fourth semiconductor layer 42. The Al composition ratio increases in a curved pattern from the third semiconductor layer 41 to the half way to the fifth semiconductor layer 43, then increases in a stepwise fashion. In the region where the Al composition ratio changes in the curved pattern, the rate of increase of the Al composition ratio is larger as it gets closer to the fifth semiconductor layer 43. When the fourth semiconductor layer 42 is configured in this way, it is also possible to reduce the leakage current in the semiconductor device 100.

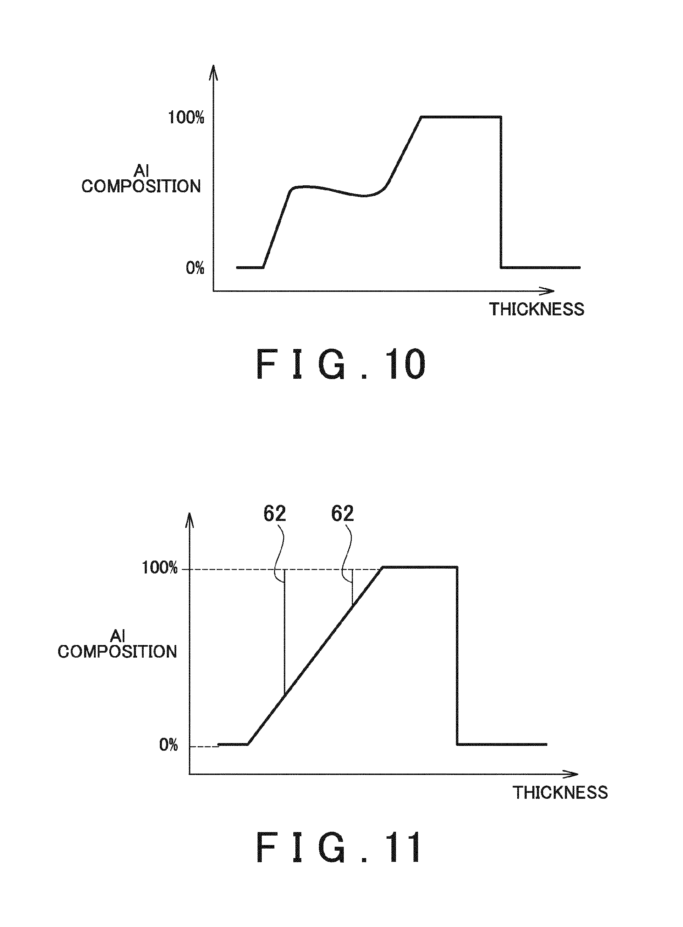

Fig. 10 illustrates another example of a change in the Al composition ratio in the fourth semiconductor layer 42. The Al composition ratio linearly increases from the third semiconductor layer 41 to the half way of the fifth semiconductor layer 43, then once decreases and subsequently increases linearly again. When the fourth semiconductor layer 42 is configured in this way, it is also possible to reduce the leakage current in the semiconductor device 100.

Fig. 11 illustrates another example of a change in the Al composition ratio in the fourth semiconductor layer 42. The fourth semiconductor layer 42 has a thickness smaller than that of the fifth semiconductor layer 43, and it has a layer 62 which has the same composition as that of the fifth semiconductor layer 43 at a position away from the fifth semiconductor layer 43. The fourth semiconductor layer 42 includes an AlN layer having a thickness of, for example, 1 nm in the middle of the fourth semiconductor layer. The fourth semiconductor layer 42 may include a plurality of layers 62 with a constant interval provided therebetween. In this way, it is possible to further accommodate warpage. When the fourth semiconductor layer 42 is configured in this way, it is also possible to reduce the leakage current in the semiconductor device 100.

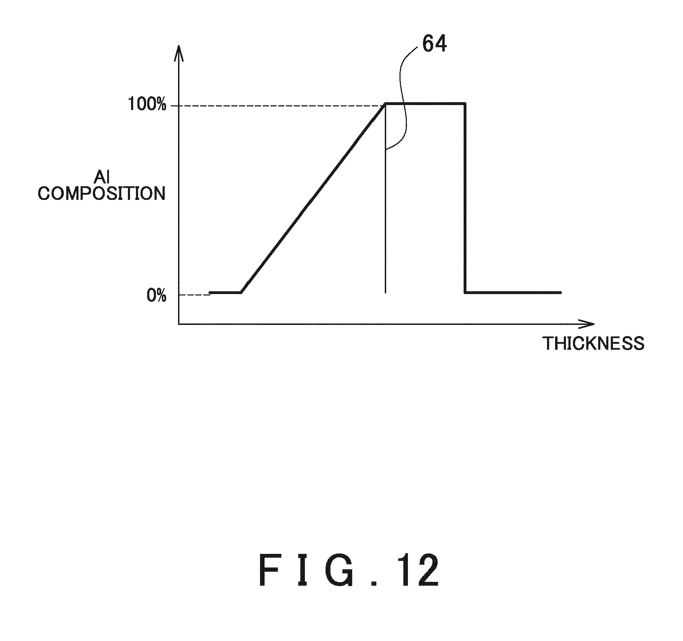

Fig. 12 illustrates another example of a change in the Al composition ratio in the fourth semiconductor layer 42. The fourth semiconductor layer 42 has a layer 64 which has a smaller thickness than that of the fifth semiconductor layer 43 at the interface with at least one of the third semiconductor layer 41 and the fifth semiconductor layer 43. The layer 64 has a different composition than the composition of the layer that is in contact with the fourth semiconductor layer 42 at the interface. For example, the fourth semiconductor layer 42 may have the layer 64 that has the same composition as that of the third semiconductor layer 41 at the interface with the fifth semiconductor layer 43.

More specifically, the fourth semiconductor layer 42 may have a GaN layer that has a thickness of, for example, 1 nm at the interface with the fifth semiconductor layer 43. In this way, it is possible to enhance the crystallinity of the surface of the second buffer region 40. When the fourth semiconductor layer 42 is configured in this way, it is also possible to reduce the leakage current in the semiconductor device 100.

A method of manufacturing the semiconductor device 100 will be now described. The method of manufacturing the semiconductor 100 includes providing the substrate 10, forming the interlayer 20 on the substrate 10, forming the first buffer region 30 on the interlayer 20 and over the substrate 10, forming the second buffer region 40 on the first buffer region 30, forming the active layer 70 on the second buffer region 40, and forming at least two electrodes (72, 74, 76) on the active layer 70.

Providing the substrate 10 may include providing an Si(111) substrate or an Si(110) substrate which is fabricated through a CZ method. Forming the interlayer 20 may include maintaining the substrate temperature at 1100°C and epitaxially growing AlN to a thickness of about 40 nm on the main plane of the substrate 10 by a Metal Organic Chemical Vapor Deposition (MOCVD) method using a TMA (trimethyl aluminum) gas and a NH3 gas. In the examples hereunder described, epitaxial growth is performed by the MOCVD method. In the hereunder examples, growth temperatures for growing layers may be equal to or higher than 900°C and equal to or less than 1300°C.

Forming the first buffer region 30 includes repeating at least one cycle in which the first semiconductor layer 31 with the first lattice constant is formed and the second semiconductor layer 32 with the second lattice constant is subsequently formed. The second lattice constant is different from the first lattice constant. The first lattice constant may be smaller than the lattice constant of the substrate 10. The second lattice constant may be smaller than the first lattice constant.

Forming the first semiconductor layer 31 may include epitaxially growing GaN on the interlayer 20 by supplying a TMG (trimethyl gallium) gas and a NH3 gas after the interlayer 20 is formed.. Forming the second semiconductor layer 32 may include, after the first semiconductor layer 31 has been formed, epitaxially growing AlN on the first semiconductor layer 31 by supplying a TMA gas and a NH3 gas to deposit AlN to a thickness of 60 nm. The step of forming the first buffer region 30 may repeat a cycle of these two formation steps and may adjust the growth times to vary the thicknesses of the first semiconductor layers 31 or GaN to, for example, 130 nm, 150 nm, 180 nm, 210 nm, 250 nm, and 300 nm.

Forming the second buffer region 40 includes repeating at least one cycle in which the third semiconductor layer 41 with the third lattice constant is formed, the fourth semiconductor layer 42 with the fourth lattice constant is formed, and the fifth semiconductor layer 43 with the fifth lattice constant is formed. The third lattice constant is substantially same as the first lattice constant. The fifth lattice constant is substantially same as the second lattice constant. The fourth lattice constant has a value between the third lattice constant and the fifth lattice constant.

Forming the third semiconductor layer 41 may include epitaxially growing GaN on the second semiconductor layer 32 that is the top layer of the first buffer region 30 by supplying a TMG gas and an NH3 gas. Forming the fourth semiconductor layer 42 may include epitaxially growing AlGaN on the third semiconductor layer 41 by supplying a TMG gas, a TMA gas and an NH3 gas to deposit AlGaN to a thickness of 60 nm. At this point, the fourth semiconductor layer 42 in which the Al composition ratio is inclined can be formed by adjusting the gas flow rate of the TMA gas to be gradually increased.

Forming the fifth semiconductor layer 43 may include epitaxially growing AlN on the fourth semiconductor layer 42 by supplying a TMA gas and a NH3 gas to deposit AlN to a thickness of 60 nm. The step of forming the second buffer region 40 may repeat a cycle of these three formation steps and may adjust the growth times to vary the thicknesses of the third semiconductor layers 41 or GaN to, for example, 300 nm, 370 nm, 470 nm, 600 nm, 790 nm, and 1040 nm.

Forming the active layer 70 includes forming the electron transit layer 50 and forming the electron supply layer 60 on the electron transit layer 50. Forming the electron transit layer 50 may include epitaxially growing GaN on the fifth semiconductor layer 43 that is the top layer of the second buffer region 40 by supplying a TMG gas and an NH3 gas to deposit GaN to a thickness of 1200 nm. Forming the electron supply layer 60 may include epitaxially growing Si-dopted AlGaN on the electron transit layer 50 by supplying a TMA gas, a TMG gas, an NH3 gas, and an SiH4 gas to deposit Si-dopted AlGaN to a thickness of 25 nm.

Forming at least two electrodes (72, 74, 76) may include forming a silicon oxide film on the surface of the substrate 10, forming openings for the electrodes, and forming the electrodes. Forming a silicon oxide film on the surface of the substrate 10 may include removing the substrate 10 out of an MOCVD apparatus, placing the substrate 10 within a plasma CVD apparatus, and then forming the silicon oxide film on the whole surface of the substrate 10.

Forming openings for the electrodes may include forming openings for a source electrode and a drain electrode by performing photolithography and etching. Forming the electrodes may include depositing Ti and Al sequentially by electron beam evaporation, and then forming the source electrode 72 and the drain electrode 76 that are in ohmic contact with the electron supply layer 60 by a lift-off method.

Forming openings for the electrodes may include forming the openings for the electrodes by performing photolithography and etching. Forming the electrodes may includes depositing Pt and Au sequentially by electron beam evaporation, and then forming the gate electrode 74 that is in schottky contact with the electron supply layer 60 by a lift-off method.

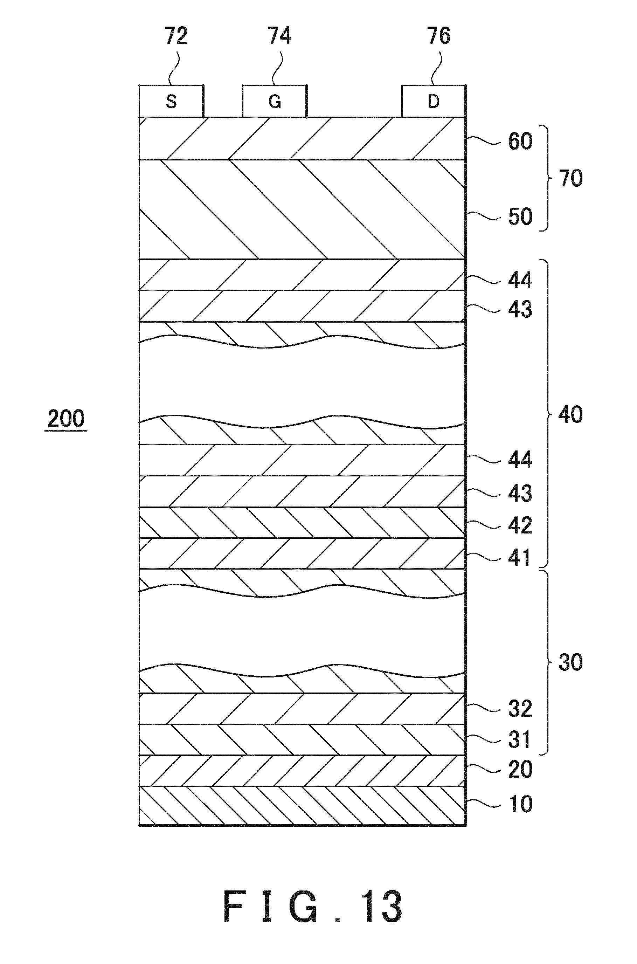

Fig. 13 is a sectional view of a semiconductor device 200 according to the second embodiment of the invention. The semiconductor device 200 has the second buffer region 40 that has a different configuration from that of the semiconductor device 100. Configuration of the semiconductor device 200 may be same as the semiconductor device 100 except for the second buffer region 40.

A composite layer of the second buffer region 40 in the semiconductor device 200 further includes a sixth semiconductor layer 44 on the fifth semiconductor layer 43. The sixth semiconductor layer 44 is formed in contact with the fifth semiconductor layer 43. The sixth semiconductor layer 44 has a sixth lattice constant between the third lattice constant and the fifth lattice constant. The sixth semiconductor layer 44 has a coefficient of thermal expansion between those of the third semiconductor layer 41 and the fifth semiconductor layer 43. The sixth semiconductor layer 44 includes Alₓ₆In_{y6}Ga_{1-x6-y6}N (where 0 < x6 ≤ 1, 0 ≤ y6 ≤ 1, x6+y6 ≤ 1).

The sixth semiconductor layer 44 is made of, for example, AlGaN. The sixth semiconductor layer 44 has a lattice constant and a coefficient of thermal expansion that correspond to the Al composition ratio. The lattice constant of the sixth semiconductor layer 44 increases from a point of the layer nearest to the substrate 10 toward a point of the layer farthest from the substrate 10. In other words, the Al ratio in the sixth semiconductor layer 44 decreases from the closest toward the farthest to the substrate 10. The first to sixth semiconductor layers 31 to 44 have Al composition relationships x1 ≈ x3, x2 ≈ x5, x1, x3 ≤ x4, x6 ≤ x2, x5.

The second buffer region 40 has, for example, six composite layers in which the third semiconductor layer 41, the fourth semiconductor layer 42, the fifth semiconductor layer 43, and the sixth semiconductor layer 44 are sequentially deposited. The thicknesses of the third semiconductor layers 41 in the composite layers are the substrate 10 are, for example, 230 nm, 310 nm, 410 nm, 540 nm, 730 nm, and 980 nm respectively, stated from the one closest to the substrate 10. The thicknesses of the fourth semiconductor layers 42 may be constant and may be, for example, 60 nm. The thicknesses of the fifth semiconductor layers 43 may be constant and may be, for example, 60 nm. The thicknesses of the sixth semiconductor layers 44 may be constant and may be, for example, 60 nm.

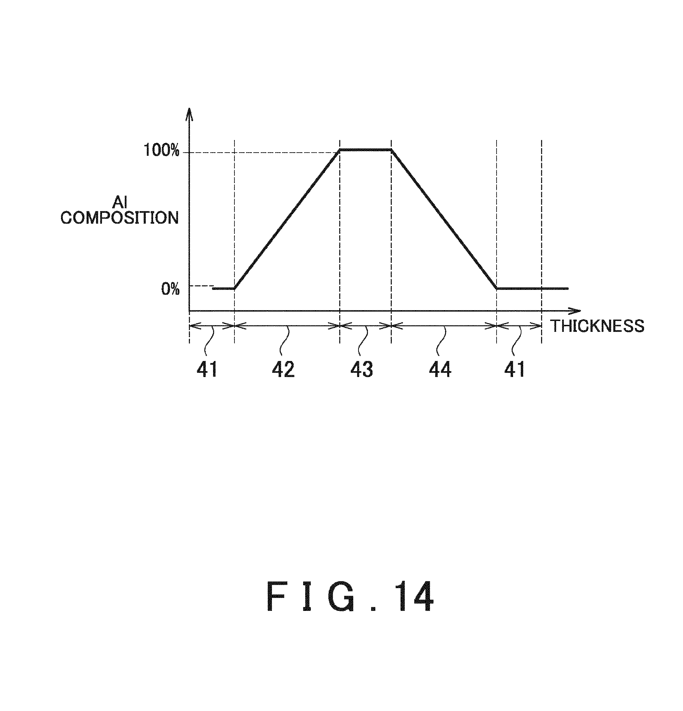

Fig. 14 illustrates a change in the Al composition ratio in the thickness direction of the second buffer region 40. Here, the Al ratio in the third semiconductor layer 41 is 0%, and the Al ratio in the fifth semiconductor layer 43 is 100%. However, the Al ratios are not limited to this. The Al ratio in the fourth semiconductor layer 42 linearly increases from the third semiconductor layer 41 toward the fifth semiconductor layer 43. An Al ratio in the sixth semiconductor layer 44 linearly decreases from the fifth semiconductor layer 43 toward the third semiconductor layer 41. Under the same conditions as those of the semiconductor device 100 including the thickness of each layer, the material of each layer, the applied voltages and so on, a leakage current through the semiconductor device 200 was measured, and the measurement result was about 1E-9 A. This result showed that the leakage current was further reduced compared to the leakage current flowing through the semiconductor device 100.

A method of manufacturing the semiconductor device 200 according to the second embodiment of the invention will be now described. The method of manufacturing the semiconductor device 200 includes the same manufacturing steps as those of the semiconductor device 100 except for a step of forming the second buffer region 40, and therefore the same steps will not be hereunder described. Forming the second buffer region 40 includes at least one cycle in which the third semiconductor layer 41 with the third lattice constant is formed, the fourth semiconductor layer 42 with the fourth lattice constant is formed, the fifth semiconductor layer 43 with the fifth lattice constant is formed, and the sixth semiconductor layer 44 with the sixth lattice constant is formed in the stated order. The third lattice constant is substantially same as the first lattice constant. The fifth lattice constant is substantially same as the second lattice constant. The sixth lattice constant has a value between the third lattice constant and the fifth lattice constant. The fourth lattice constant has a value between the third lattice constant and the fifth lattice constant.

Forming the third semiconductor layer 41 may include epitaxially growing GaN on the second semiconductor layer 32 that is the top layer of the first buffer region 30 by supplying a TMG gas and an NH3 gas. Forming the fourth semiconductor layer 42 may include epitaxially growing AlGaN on the third semiconductor layer 41 by supplying a TMG gas, a TMA gas and an NH3 gas to deposit AlGaN in 60 nm thick. At this point, the fourth semiconductor layer 42 in which the Al composition ratio is inclined by adjusting the gas flow rate of the TMA gas to be gradually increased.

Forming the fifth semiconductor layer 43 may include epitaxially growing AlN on the fourth semiconductor layer 42 by supplying a TMA gas and a NH3 gas to deposit AlN to a thickness of 60 nm. Forming the sixth semiconductor layer 44 may include epitaxially growing AlGaN on the fourth semiconductor layer 42 by supplying a TMG gas, a TMA gas and an NH3 gas to deposit AlGaN to a thickness of 60 nm. At this point, the sixth semiconductor layer 44 in which the Al composition ratio is inclined can be formed by adjusting the gas flow rate of the TMA gas to be gradually decreased. In the step of forming the second buffer region 40, a cycle in which the semiconductor layers including the third semiconductor layer 41 to the sixth semiconductor layer 44 are fabricated is iterated. At this point, the thicknesses of the third semiconductor layers 41 may be varied, for example, 230 nm, 310 nm, 410 nm, 540 nm, 730 nm, and 980 nm, by adjusting the growth times of the layers.

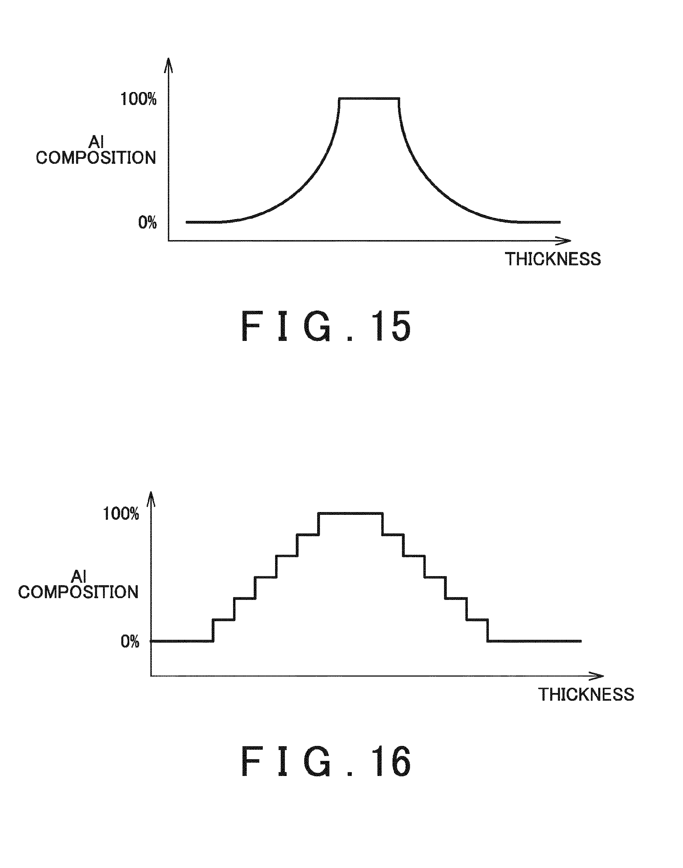

Fig. 15 illustrates another example of a change in the Al composition ratio in fourth and sixth semiconductor layers 42 and 44. The Al composition ratio in the fourth semiconductor layer 42 increases in a curved pattern from the third semiconductor layer 41 to the fifth semiconductor layer 43. The rate of increase of the Al composition ratio becomes larger as it gets closer to the fifth semiconductor layer 43.

The Al composition ratio in the sixth semiconductor layer 44 decreases in a curved pattern from the fifth semiconductor layer 43 to the third semiconductor layer 41. The rate of decrease of the Al composition ratio becomes larger as it gets closer to the third semiconductor layer 41. When the fourth semiconductor layer 42 and the sixth semiconductor layer 44 are configured in this way, it is also possible to reduce the leakage current in the semiconductor device 200 to a value lower than that of the semiconductor device 100.

Fig. 16 illustrates another example of a change in the Al composition ratio in the fourth and sixth semiconductor layers 42 and 44. The Al composition ratio in the fourth semiconductor layer 42 increases by a step of 5% from the third semiconductor layer 41 to the fifth semiconductor layer 43. The Al composition ratio in the sixth semiconductor layer 44 decreases by a step of 5% from the fifth semiconductor layer 43 to the third semiconductor layer 41. When the fourth semiconductor layer 42 and the sixth semiconductor layer 44 are configured in this way, the leakage current in the semiconductor device 200 was reduced to a value lower than that of the semiconductor device 100.

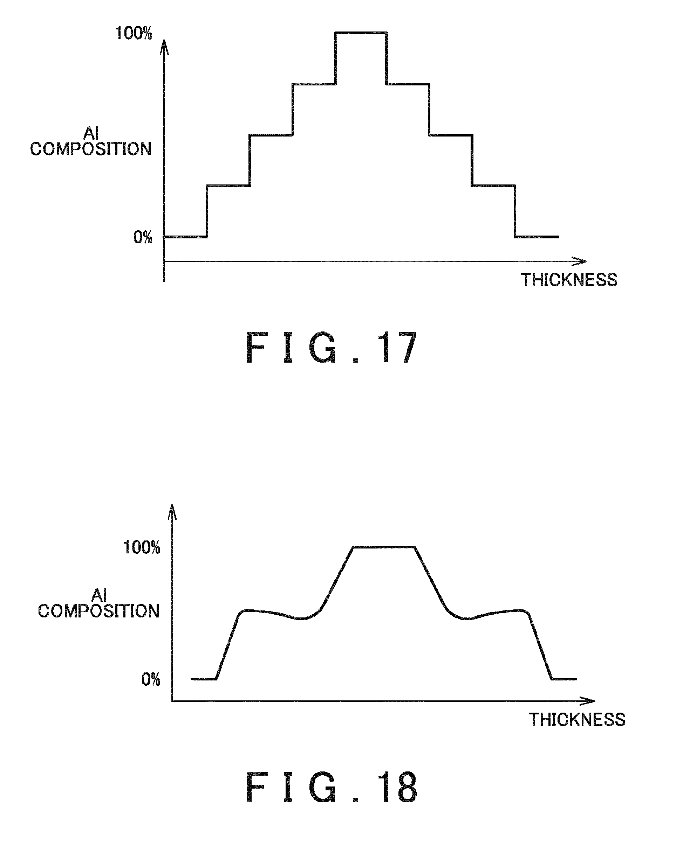

Fig. 17 illustrates another example of a change in the Al composition ratio in the fourth and sixth semiconductor layers 42 and 44. The Al composition ratio in the fourth semiconductor layer 42 increases by a step of 25% from the third semiconductor layer 41 to the fifth semiconductor layer 43. The Al composition ratio in the sixth semiconductor layer 44 decreases by a step of 25% from the fifth semiconductor layer 43 to the third semiconductor layer 41. When the fourth semiconductor layer 42 and the sixth semiconductor layer 44 are configured in this way, the leakage current in the semiconductor device 200 was reduced to a value lower than that of the semiconductor device 100.

Fig. 18 illustrates another example of a change in the Al composition ratio in the fourth and sixth semiconductor layers 42 and 44. The Al composition ratio in the fourth semiconductor layer 42 linearly increases from the third semiconductor layer 41 to the half way of the fifth semiconductor layer 43, then once decreases and linearly increases again. The Al composition ratio in the sixth semiconductor layer 44 linearly decreases from the third semiconductor layer 41 to the half way of the fifth semiconductor layer 43, then once increases and linearly decreases again. When the fourth semiconductor layer 42 and the sixth semiconductor layer 44 are configured in this way, the leakage current in the semiconductor device 200 was reduced to a value lower than that of the semiconductor device 100.

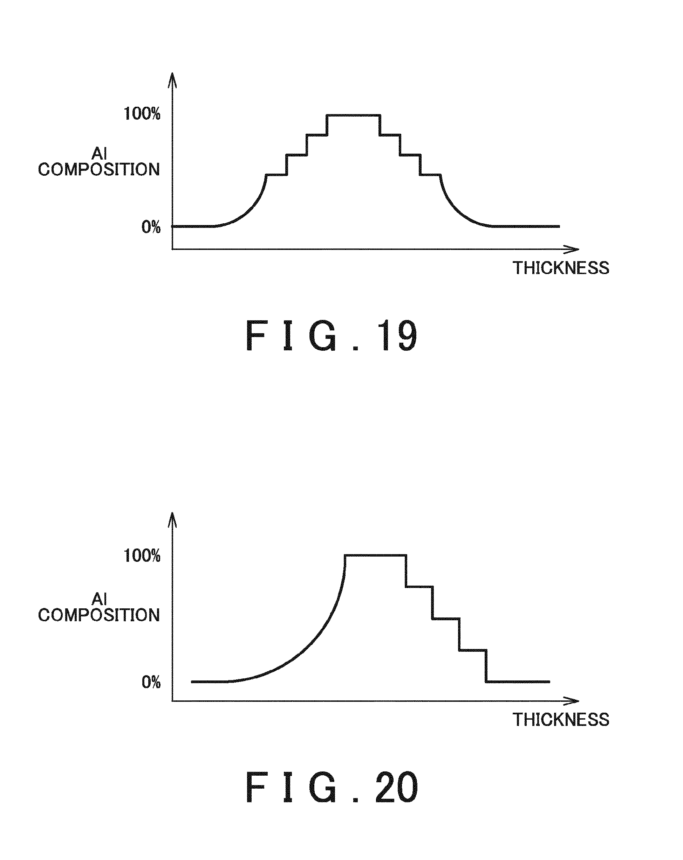

Fig. 19 illustrates another example of a change in the Al composition ratio in the fourth and sixth semiconductor layers 42 and 44. The Al composition ratio in the fourth semiconductor layer 42 increases in a curved pattern from the third semiconductor layer 41 to the half way of the fifth semiconductor layer 43, then increases in a stepwise fashion. In the region where the Al composition ratio changes in the curved pattern, the rate of increase of the Al composition ratio is larger as it gets closer to the fifth semiconductor layer 43.

The Al composition ratio in the sixth semiconductor layer 44 decreases in a stepwise fashion from the fifth semiconductor layer 43 to the half way of the third semiconductor layer 41, then decreases in a curved pattern. In the region where the Al composition ratio changes in the curved pattern, the rate of increase of the Al composition ratio is larger as it is closer to the third semiconductor layer 41. When the fourth semiconductor layer 42 and the sixth semiconductor layer 44 are configured in this way, the leakage current in the semiconductor device 200 was reduced to a value lower than that of the semiconductor device 100.

Fig. 20 illustrates another example of a change in the Al composition ratio in the fourth and sixth semiconductor layers 42 and 44. The Al composition ratio in the fourth semiconductor layer 42 increases in a curved pattern from the third semiconductor layer 41 to the fifth semiconductor layer 43. The rate of increase of the Al composition ratio is larger as it gets closer to the fifth semiconductor layer 43.

The Al composition ratio in the sixth semiconductor layer 44 decreases in a curved pattern from the fifth semiconductor layer 43 to the third semiconductor layer 41. When the fourth semiconductor layer 42 and the sixth semiconductor layer 44 are configured in this way, it is also possible to reduce the leakage current in the semiconductor device 200 to a value lower than that of the semiconductor device 100.

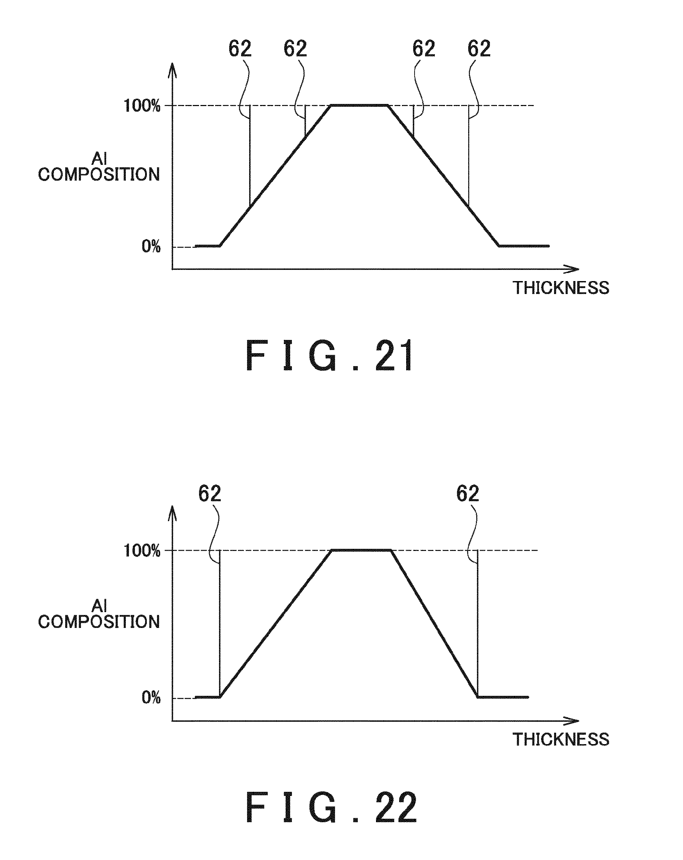

Fig. 21 illustrates another example of a change in the Al composition ratio in the fourth and sixth semiconductor layers 42 and 44. The fourth semiconductor layer 42 and the sixth semiconductor layer 44 has the layer 62 which has a thickness smaller than that of the fifth semiconductor layer 43 and has the same composition as that of the fifth semiconductor layer 43 at a position away from the fifth semiconductor layer 43. The fourth semiconductor layer 42 and the sixth semiconductor layer 44 may have a plurality of the layers 62 with a constant interval therebetween. The fourth semiconductor layer 42 and the sixth semiconductor layer 44 include an AlN layer having a thickness of, for example, about 1 nm in the middle of the corresponding semiconductor layer. In this way, it is possible to further accommodate the warpage. When the fourth semiconductor layer 42 and the sixth semiconductor layer 44, the leakage current in the semiconductor device 200 was reduced to a value lower than that of the semiconductor device 100.

The fourth semiconductor layer 42 and the sixth semiconductor layer 44 may have a semiconductor layer having a smaller thickness than that of the fifth semiconductor layer 43 at least one of at the interface with the fifth semiconductor layer 43 and the interface with the third semiconductor layer 41. This semiconductor layer has a different composition than that of the layer adjacent to the fourth semiconductor layer 42 or the sixth semiconductor layer 44.

Fig. 22 illustrates an example of a change in the Al composition ratio in a case where the semiconductor layer 62 having a smaller thickness than that of the fifth semiconductor layer 43 is formed at the interface between the third semiconductor layer 41 and the fourth semiconductor layer 42 or at the interface between the fifth semiconductor layer 43 and the sixth semiconductor layer 44. For example, the fourth semiconductor layer 42 includes the semiconductor layer 62 that has the same composition as that of the fifth semiconductor layer 43 at the interface with the third semiconductor layer 41. The semiconductor layer 62 may be an AlN layer that has a thickness of about 1 nm.

The sixth semiconductor layer 44 may include the semiconductor layer 62 at the interface with the third semiconductor layer 41. In this way, it is possible to control the warpage in the plus direction. When the fourth semiconductor layer 42 and the sixth semiconductor layer 44 are configured in this way, it is also possible to reduce the leakage current in the semiconductor device 200 to a value lower than that of the semiconductor device 100.

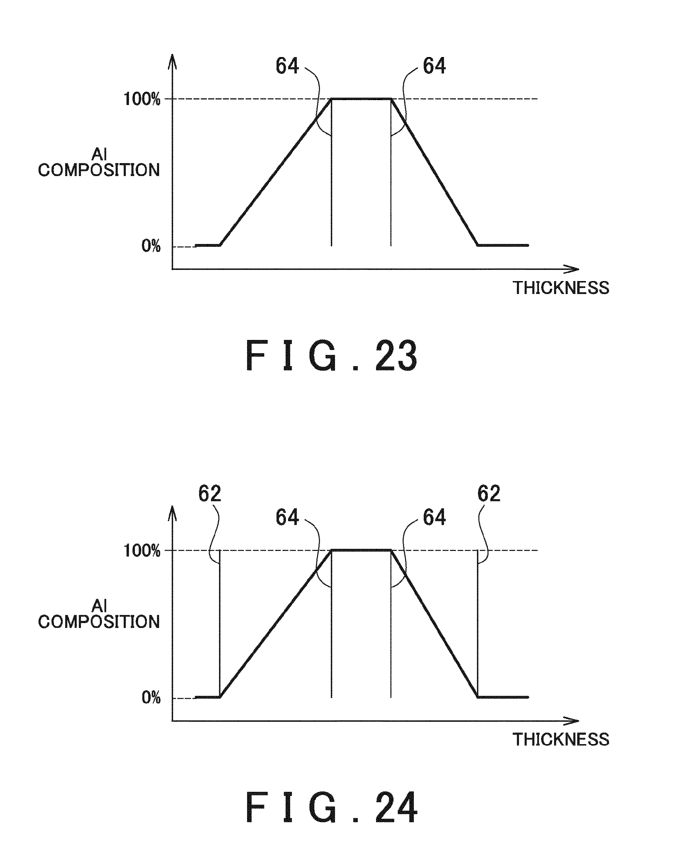

Fig. 23 illustrates an example of a change in the Al composition ratio of a case where the semiconductor layer 64 having a smaller thickness than that of the fifth semiconductor layer 43 is formed at the interface between the fourth semiconductor layer 42 and the fifth semiconductor layer 43 or at the interface between the fifth semiconductor layer 43 and the sixth semiconductor layer 44. For example, the fourth semiconductor layer 42 includes a semiconductor layer that has the same composition as that of the third semiconductor layer 41 at the interface with the fifth semiconductor layer 43. The semiconductor layer 64 may be a GaN layer that has a thickness of about 2 nm.

The sixth semiconductor layer 44 may include the semiconductor layer 64 at the interface with the fifth semiconductor layer 43. In this way, the crystallinity of the surface of the second buffer region 40 can be improved and therefore the surface was planarized. When the fourth semiconductor layer 42 and the sixth semiconductor layer 44 are configured in this way, it is also possible to reduce the leakage current in the semiconductor device 200 to a value lower than that of the semiconductor device 100.

Fig. 24 illustrates an example of a change in the Al composition ratio of a case where the semiconductor layer 62 or the semiconductor layer 64 is formed at the interface between the fourth semiconductor layer 42 or the sixth semiconductor layer 44 and the layer adjacent thereto. The semiconductor layer 62 and the semiconductor layer 64 formed at the corresponding interface may be the same as the semiconductor layer 62 and the semiconductor layer 64 shown in Fig. 22 and Fig. 23.

In this example, the fourth semiconductor layer 42 may have an AlN layer that has a thickness of about 0.2 nm at the interface with the third semiconductor layer 41. The fourth semiconductor layer 42 may have a GaN layer that has a thickness of about 0.2 nm at the interface with the fifth semiconductor layer 43. The sixth semiconductor layer 44 may have a GaN layer that has a thickness of about 0.2 nm at the interface with the fifth semiconductor layer 43. The sixth semiconductor layer 44 may have an AlN layer that has a thickness of about 0.2 nm at the interface with the first semiconductor layer 31.

In this way, it is possible to improve the crystallinity and the flatness of the surface of the second buffer region 40 while the warpage is accommodated. When the fourth semiconductor layer 42 and the sixth semiconductor layer 44 are configured in this way, it is also possible to reduce the leakage current in the semiconductor device 200 to a value lower than that of the semiconductor device 100.

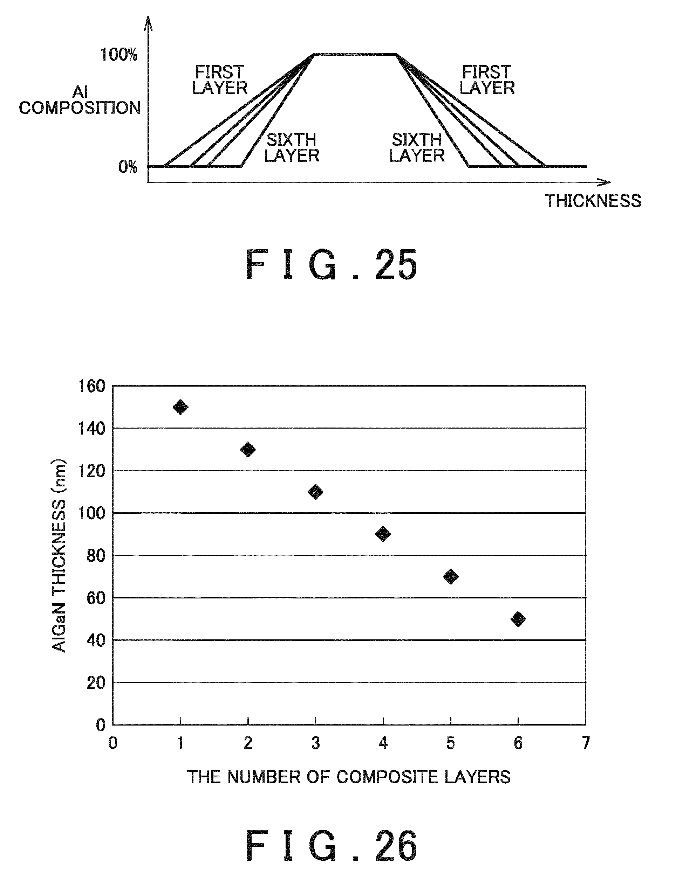

Fig. 25 illustrates examples of changes in the Al composition ratio in each composite layer in a case where layer thicknesses of the fourth and sixth semiconductor layers 42 and 44 in each composite layer of the second buffer region 40 are varied in the semiconductor device 200. Here, the composite layer closest to the substrate 10 is a first layer and the composite layer farthest to the substrate 10 is a sixth layer.

In this example, the thicknesses of the fourth semiconductor layer 42 and the sixth semiconductor layer 44 are decreased as the distance from the substrate 10 increases. As a result, a gradient of the Al composition ratio in the fourth semiconductor layer 42 and the sixth semiconductor layer 44 increases from the first composite layer toward the sixth composite layer.

Fig. 26 illustrates the layer thicknesses of the fourth semiconductor layer 42 and the sixth semiconductor layer 44 in each composite layer of the example shown in Fig. 25. The horizontal axis in Fig. 26 shows the composite layer number from the first layer to the sixth layer. The thicknesses of the fourth semiconductor layers 42 and the sixth semiconductor layers 44 decrease at a constant rate from the first layer to the sixth layer. When the second buffer region 40 is configured in this way, the leakage current in the semiconductor device 200 was reduced to a value lower than that of the semiconductor device 100.

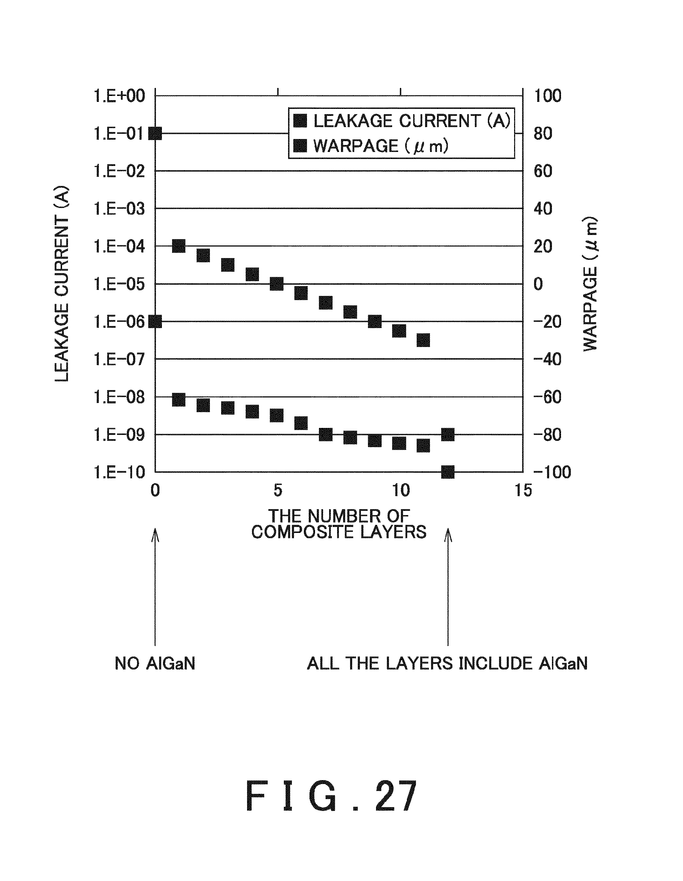

Fig. 27 illustrates relationships between a leakage current and an amount of warpage in the example where the number of the composite layers in the second buffer region 40 is changed. In this example, the total thickness of the semiconductor device 200 was made constant, and the total number of the composite layers in the first buffer region 30 and the second buffer region 40 was twelve. The horizontal axis in Fig. 27 shows the number of the composite layers that include the AlGaN layer, or the number of the composite layers in the second buffer region 40.

When the number of the composite layers in the second buffer region 40 is zero (in other words, when the second buffer region 40 does not exist), only the first buffer region 30 serves as the buffer layer. In this case, the leakage current has a value of 1E-6 A, and the amount of warpage is large in the plus direction.

When the second buffer region 40 has a single composite layer, the leakage current is decreased to 1E-8 A or less, and the amount warpage is also largely decreased. As the number of the composite layers in the second buffer region 40 increases, the leakage current and the amount of warpage are decreased.

When the number of the composite layers in the second buffer region 40 is twelve (in other words, when the first buffer region 30 does not exist), only the second buffer region 40 serves as the buffer layer. In this case, the leakage current is decreased to 1E-10A, however the amount of warpage is large in the minus direction. Therefore, the substrate is largely warped downward and this would hamper the device fabrication. For this reason, it is advantageous to combine the first buffer region 30 and the second buffer region 40.

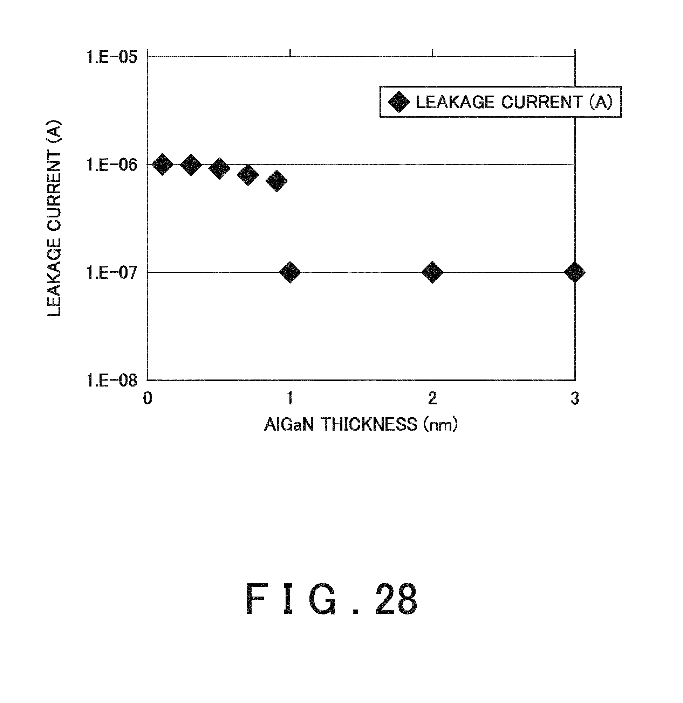

Fig. 28 illustrates a relationship between the leakage current and the thicknesses of the fourth semiconductor layer 42 and the sixth semiconductor layer 44 in the second buffer region 40. The horizontal axis in Fig. 28 shows the thickness of the single AlGaN layer, in other words, the thickness of the single fourth semiconductor layer 42 and the single sixth semiconductor layer 44.

When the thicknesses of the fourth semiconductor layer 42 and the sixth semiconductor layer 44 are less than 1 nm, the leakage current is about 1E-6 A. When the thicknesses of the fourth semiconductor layer 42 and the sixth semiconductor layer 44 are 1 nm or more, the leakage current is decreased to about 1E-7 A. Thus, it is preferable that the thicknesses of the fourth semiconductor layer 42 and the sixth semiconductor layer 44 be 1 nm or more.

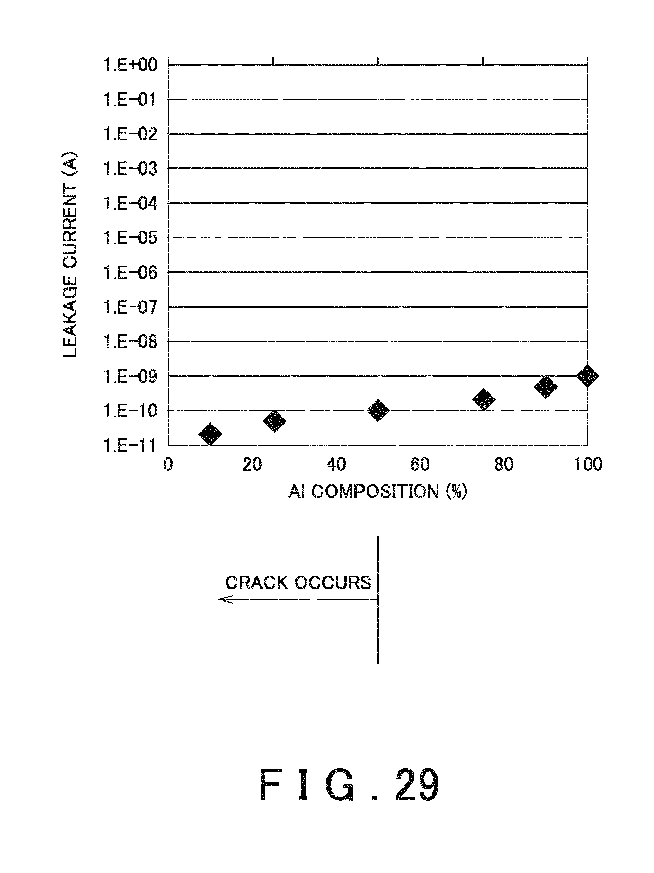

Fig. 29 illustrates relationship between the Al composition ratio in the fifth semiconductor layer 43 and the leakage current in a case where all the fifth semiconductor layers 43 are AlGaN. In this case, the largest Al composition ratio in the fourth semiconductor layer 42 and the sixth semiconductor layer 44 corresponds to the Al composition ratio of the fifth semiconductor layer 43. Referring to Fig. 29, the leakage current decreases as the Al composition ratio in the fifth semiconductor layer 43 decreases. However, when the Al composition ratio is decreased to 50% or less, the warpage in the second buffer region 40 cannot be accommodated any more, and crack could occur in the active layer 70. The fifth semiconductor layer 43 may be made of AlGaN in which the Al composition ratio is more than 50%.

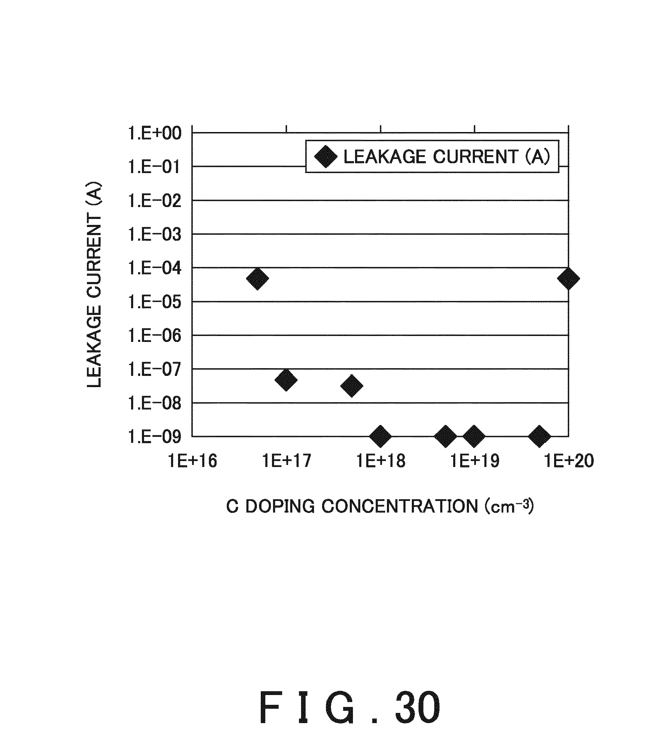

Fig. 30 illustrates relationship between the leakage current and a C doping concentration in the second semiconductor layer 32 and the fifth semiconductor layer 43. When the C doping concentration is no less than 1E17 cm⁻³, and no more than 9E19 cm⁻³, the leakage current becomes about 7E-8A or less, which is favorable. However, when the C doping concentration is less than 1E17 cm⁻³, or more than 1E20 cm⁻³, the resistivity of the second semiconductor layer 32 and the fifth semiconductor layer 43 becomes low and consequently the leakage current is increased, which is not favorable. Therefore, it is preferable that the second semiconductor layer 32 and the fifth semiconductor layer 43 are doped with C at the doping concentration of from 1E17 cm⁻³, to no more than 1E20 cm⁻³.

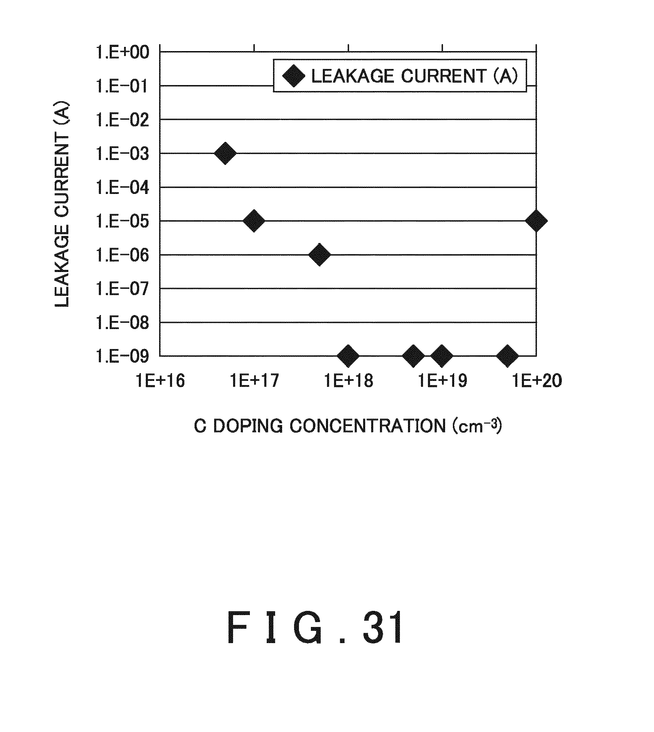

Fig. 31 illustrates relationship between the leakage current and a C doping concentration in the first semiconductor layer 31 and the third semiconductor layer 41. When the C doping concentration is no less than 1E18 cm⁻³, and no more than 9E19 cm⁻³, the leakage current becomes about 1E-9A or less, which is favorable. However, when the C doping concentration is less than 1E17 cm⁻³, or more than 1E20 cm⁻³, the resistivity of the first semiconductor layer 31 and the third semiconductor layer 41 becomes low and consequently the leakage current is increased, which is not favorable. Therefore, it is preferable that the first semiconductor layer 31 and the third semiconductor layer 41 are doped with C at the doping concentration of from 1E18 cm-3 to no more than 1E20 cm-3.

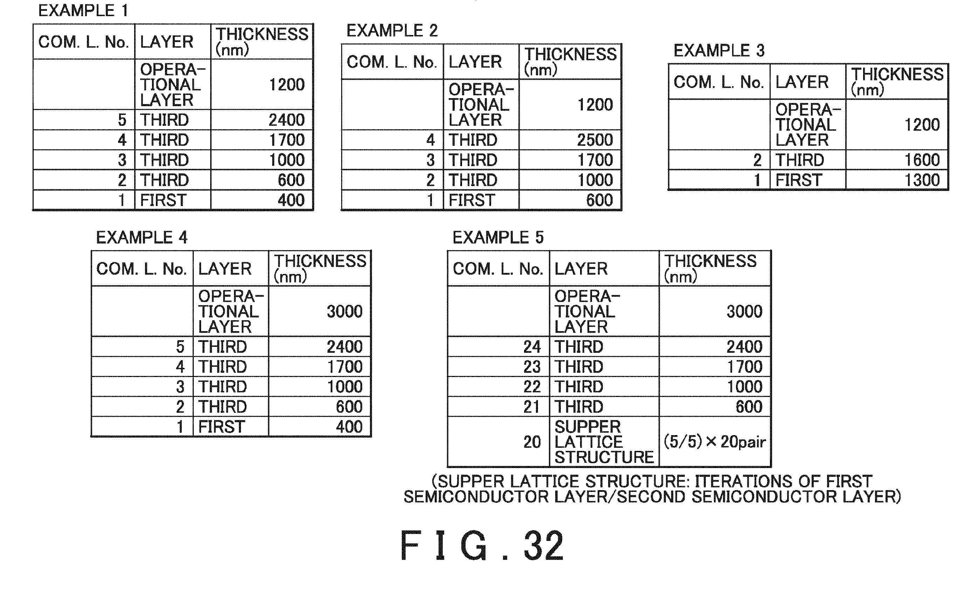

Fig. 32 illustrates Examples 1 to 5 in which the layer thickness of the first semiconductor layer 31 and the number of the composition layers in the first buffer region 30, and the number of the composition layers and the layer thickness of the third semiconductor layer 41 in the second buffer region 40 are varied. In each example, the number of the composition layer refers to the order of the composition layer which is arranged in the stack on the interlayer 20, and the thickness indicates the layer thickness of the first semiconductor layer 31 or the third semiconductor layer 41 in the corresponding composition layer.

In Examples 1 to 5, the thickness of the third semiconductor layer 41 is larger than that of the first semiconductor layer 31. The thickness of the third semiconductor layer 41 in each composite layer in the second buffer region 40 increases gradually as the distance from the substrate 10 increases. In Example 5, twenty pairs of the first semiconductor layer 31 that has a thickness of 5 nm and the second semiconductor layer 32 that has a thickness of 5 nm form a superlattice structure.

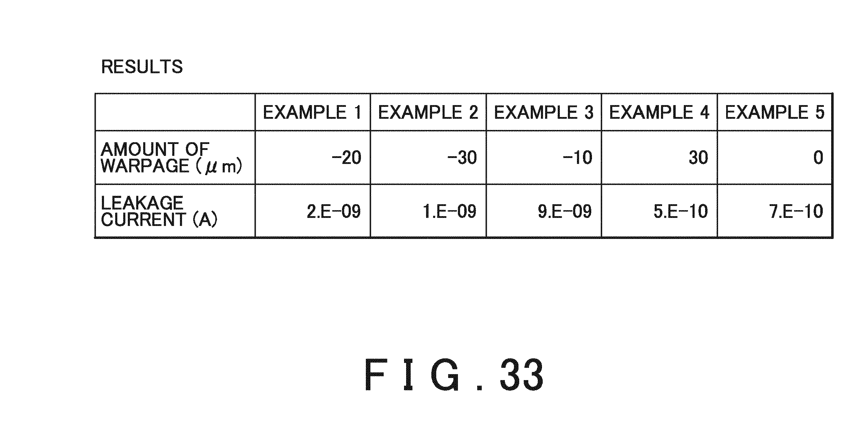

Fig. 33 illustrates measurement results of the amount of warpage and the leakage current in Examples 1 to 5. In each example, the leakage current was reduced to 9E-9A or less, and the amount of the warpage was accommodated in a range from +30 to -30. It is understood from the results of the measurements that it is preferable that the thickness of the first semiconductor layer 31 in the first buffer region 30 be 400 nm or more, the thickness of the third semiconductor layer 41 in the composite layer in the second buffer region 40 be larger than the thickness of the first semiconductor layer 31, and the thicknesses of the third semiconductor layers 30 be gradually increased as they are situated away from the substrate.

The layer thicknesses of the first semiconductor layer 31 and the third semiconductor layer 41 may be 5 nm or more, and a thickness of the thickest layer may be no less than 400 nm and no more than 3000 nm. It is preferable that the thickest layer among the first semiconductor layers 31 and the third semiconductor layers 41 have a thickness of 400 nm or more in order to accommodate warpage. It is also preferable in terms of production efficiency that the thickest layer have a thickness of 3000 nm or less in order to shorten the growth time.

It is preferable that the thickness of the second semiconductor layer 32 and the fifth semiconductor layer 43 be 0.5 nm or more in order to accommodate the warpage in the first semiconductor layer 31 and the third semiconductor layer 41 and to prevent crack. It is also preferable in terms of production efficiency that the second semiconductor layer 32 and the fifth semiconductor layer 43 have a thickness of 200 nm or less in order to shorten the growth time.

It is preferable that the total thickness of the epitaxial layers including the first buffer region 30, the second buffer region 40, and the active layer 70 be 4 µm or more in order to curb the leakage current and to obtain a sufficient withstand voltage. Composition of the fourth semiconductor layer 42 and the sixth semiconductor layer 44 may not be symmetrical in a composition layer but may be any film composition as long as strain generated therein can be controlled and the leakage current can be reduced. The total number of the composition layers may be any number no less than two, and it can be changed depending on the total thickness, the amount of warpage, a dislocation density and so on.

Although the HEMT-type field-effect transistor has been described as the semiconductor devices 100 and 200, the semiconductor devices 100 and 200 are not limited to this but may be insulated gate field-effect transistors (MISFETs, MOSFETs), a Schottoky gate field-effect transistors (MESFETs) and so on. Moreover, the features of the invention can also be applied to diodes in which a cathode electrode and an anode electrode are provided in stead of the source electrode 72, the gate electrode 74, and the drain electrode 76.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

As discussed above, according to the embodiments of the invention, it is possible to realize a semiconductor device with small warpage and small leakage current, and with which films of the device can be increased, and a method of manufacturing the same.

## Claims

1. A semiconductor device comprising:
a substrate;
a first buffer region formed over the substrate;
a second buffer region formed on the first buffer region;
an active layer formed on the second buffer region; and
at least two electrodes formed on the active layer; wherein
the first buffer region includes at least one composite layer in which a first semiconductor layer having a first lattice constant and a second semiconductor layer having a second lattice constant that is different from the first lattice constant are sequentially stacked,
the second buffer region includes at least one composite layer in which a third semiconductor layer having a third lattice constant that is substantially same as the first lattice constant, a fourth semiconductor layer having a fourth lattice constant, and a fifth semiconductor layer having a fifth lattice constant that is substantially same as the second lattice constant are sequentially stacked, and
the fourth lattice constant has a value between the third lattice constant and the fifth lattice constant.

2. The semiconductor device according to claim 1, wherein
coefficients of thermal expansion of the first, second, third, fourth and fifth semiconductor layers are larger than a coefficient of thermal expansion of the substrate, and
the coefficient of thermal expansion of the fourth semiconductor layer has a value between the coefficient of thermal expansion of the third semiconductor layer and the coefficient of thermal expansion of the fifth semiconductor layer.

3. The semiconductor device according to claim 1 or 2, further comprising:
an interlayer that is disposed between the substrate and the first buffer region, and that has a lattice constant smaller than the first lattice constant and a coefficient of thermal expansion larger than a coefficient of thermal expansion of the substrate.

4. The semiconductor device according to any one of claims 1 to 3, wherein
the first, second, third, fourth and fifth semiconductor layers include nitride-based compound semiconductor.

5. The semiconductor device according to any one of claims 1 to 4, wherein
the lattice constant of the fourth semiconductor layer decreases from a side nearest to the substrate toward a side farthest from the substrate.

6. The semiconductor device according to any one of claims 1 to 5, wherein
the first lattice constant is smaller than a lattice constant of the substrate, and
the second lattice constant is smaller than the first lattice constant.

7. The semiconductor device according to any one of claims 1 to 6, wherein
the fourth semiconductor layer includes a layer that has a thickness smaller than a thickness of the fifth semiconductor layer and has a same composition as a composition of the fifth semiconductor layer, and is disposed at a position away from the fifth semiconductor layer.

8. The semiconductor device according to any one of claims 1 to 7, wherein
the fourth semiconductor layer has a layer that has a smaller thickness than a thickness of the fifth semiconductor layer at an interface with at least one of the third semiconductor layer and the fifth semiconductor layer, and the layer having a different composition than a composition of a layer that is in contact with the fourth semiconductor layer at the interface.

9. The semiconductor device according to any one of claims 1 to 8, wherein
the first semiconductor layer includes Alₓ₁In_{y1}Ga_{1-x1-y1}N (where 0 ≤ x1 < 1, 0 ≤ y1 ≤ 1, x1+y1 ≤ 1),
the second semiconductor layer includes Alₓ₂In_{y2}Ga_{1-x2-y2}N (where 0 < x2 ≤ 1, 0 ≤ y2 ≤ 1, x2+y2 ≤ 1),
the third semiconductor layer includes Alₓ₃In_{y3}Ga_{1-x3-y3}N (where 0 ≤ x3 < 1, 0 ≤ y3 ≤ 1, x3+y3 ≤ 1),
the fourth semiconductor layer includes Alₓ₄In_{y4}Ga_{1-x4-y4}N (where 0 < x4 ≤ 1, 0 ≤ y4 ≤ 1, x4+y4 ≤ 1),
the fifth semiconductor layer includes Alₓ₅In_{y5}Ga_{1-x5-y5}N (where 0 < x5 ≤ 1, 0 ≤ y5 ≤ 1, x5+y5 ≤ 1),
and where x1, x3 ≤ x4 ≤ x2, x5, and
an Al ratio in the fourth semiconductor layer increases from a side nearest to the substrate toward a side farthest from the substrate.

10. The semiconductor device according to any one of claims 1 to 9, wherein
the composite layer in the second buffer region further includes a sixth semiconductor layer that has a sixth lattice constant between the third lattice constant and the fifth lattice constant, and that is disposed on the fifth semiconductor layer.

11. The semiconductor device according to claim 10, wherein
the sixth semiconductor layer has a coefficient of thermal expansion that is larger than a coefficient of thermal expansion of the substrate and between coefficients of thermal expansion of the third semiconductor layer and the fifth semiconductor layer.

12. The semiconductor device according to claim 10 or 11, wherein
the sixth semiconductor layer includes nitride-based compound semiconductor.

13. The semiconductor device according to any one of claims 10 to 12, wherein
the lattice constant of the sixth semiconductor layer increases from a side nearest to the substrate toward a side farthest from the substrate.

14. The semiconductor device according to any one of claims 10 to 13, wherein
the sixth semiconductor layer includes a layer that has a thickness smaller than a thickness of the fifth semiconductor layer, has a same composition as the fifth semiconductor layer, and is disposed at a position away from the fifth semiconductor layer.

15. The semiconductor device according to any one of claims 10 to 14, wherein
the sixth semiconductor layer has a layer that has a smaller thickness than a thickness of the fifth semiconductor layer at an interface with at least one of the fifth semiconductor layer and the third semiconductor layer, and the layer having a different composition than a composition of a layer that is in contact with the sixth semiconductor layer at the interface.

16. The semiconductor device according to any one of claims 10 to 15, wherein
the sixth semiconductor layer includes Alₓ₆In_{y6}Ga_{1-x6-y6}N (where 0 < x6 ≤ 1, 0 ≤ y6 ≤ 1, x6+y6 ≤ 1), and where x1, x3 ≤ x4, x6 ≤ x2, x5, and an Al ratio in the sixth semiconductor layer decreases from a side nearest to the substrate toward a side farthest from the substrate.

17. The semiconductor device according to any one of claims 10 to 16, wherein
thicknesses of the fourth semiconductor layer and the sixth semiconductor layer in one composite layer are different from thicknesses of the fourth semiconductor layer and the sixth semiconductor layer in another composite layer.

18. The semiconductor device according to any one of claims 10 to 17, wherein
the fourth semiconductor layer and the sixth semiconductor layer have thicknesses equal to or more than 1 nm.

19. A method of manufacturing a semiconductor device, comprising:
providing a substrate;
forming a first buffer region over the substrate;
forming a second buffer region on the first buffer region;
forming an active layer on the second buffer region; and
forming at least two electrodes on the active layer, wherein
the forming the first buffer region includes repeating at least one cycle that includes forming a first semiconductor layer with a first lattice constant and then forming a second semiconductor layer with a second lattice constant that is different from the first lattice constant,
the forming the second buffer region includes repeating at least one cycle that includes forming a third semiconductor layer with a third lattice constant that is substantially same as the first lattice constant, forming a fourth semiconductor layer with a fourth lattice constant, and then forming a fifth semiconductor layer with a fifth lattice constant that is substantially same as the second lattice constant, and
the fourth lattice constant has a value between the third lattice constant and the fifth lattice constant.

20. A method of manufacturing a semiconductor device, comprising:
providing a substrate;
forming a first buffer region over the substrate;
forming a second buffer region on the first buffer region;
forming an active layer on the second buffer region; and
forming at least two electrodes on the active layer, wherein
the forming the first buffer region includes repeating at least one cycle that includes forming a first semiconductor layer with a first lattice constant and then forming a second semiconductor layer with a second lattice constant that is different from the first lattice constant,
the forming the second buffer region includes repeating at least one cycle that includes forming a third semiconductor layer with a third lattice constant that is substantially same as the first lattice constant, forming a fourth semiconductor layer with a fourth lattice constant, forming a fifth semiconductor layer with a fifth lattice constant that is substantially same as the second lattice constant, and then forming a sixth semiconductor layer with a sixth lattice constant that is between the third lattice constant and the fifth lattice constant, and
the fourth lattice constant has a value between the third lattice constant and the fifth lattice constant.
